# EUROPÄISCHE PATENTSCHRIFT

(11) **EP 3 785 173 B1**
(45) Veröffentlichungstag und Bekanntmachung des Hinweises auf die Patenterteilung: **16.11.2022**
(21) Anmeldenummer: 19735294.1
(22) Anmeldetag: 28.06.2019
(51) Int. Cl.: G06K 19/077, H01L 23/00

(54) **VORRICHTUNG UND VERFAHREN ZUR HERSTELLUNG VON RFID TRANSPONDERN**
APPARATUS AND PROCESS FOR MANUFACTURING RFID TRANSPONDERS
DISPOSITIF ET PROCÉDÉ POUR FABRIQUER DES ÉTIQUETTES RFID

(30) Priorität: 13.07.2018 DE 102018005569
(43) Veröffentlichungstag der Anmeldung: 03.03.2021
(73) Patentinhaber: Muehlbauer GmbH & Co. KG, 93426 Roding (DE)
(72) Erfinder: HOCHMANN, Sven, 01259 Dresden (DE)
(74) Vertreter: Schmidt, Steffen J.
(86) Internationale Anmeldenummer: PCT/EP2019/067392
(87) Internationale Veröffentlichungsnummer: WO 2020/011565

(56) Entgegenhaltungen:
- EP-A1- 1 816 592
- EP-A1- 2 070 017

## Beschreibung

### Hintergrund

Hier werden eine Vorrichtung und ein Verfahren zur Herstellung von elektronischen Vorrichtungen beschrieben. Insbesondere werden eine Vorrichtung und ein Verfahren zur Herstellung von RFID-Transpondern (= Radio Frequency Identification Transponder) beschrieben.

Solche RFID-Transponder werden zum Beispiel für Etiketten, zum Beispiel Price-Tags, oder Wert- und Sicherheitsdokumente verwendet. Auch die Integration von RFID-Transpondern in Kleidungsstücke, Handtaschen, Uhren oder Gebrauchsgegenstände ist möglich, zum Beispiel um einen elektronisch auslesbaren Herkunfts- bzw. Echtheitsnachweis in diese Gegenstände zu integrieren.

Ein RFID-Transponder, hat im Wesentlichen einen Halbleiterchip und eine zum Beispiel als Schleifenantenne ausgestaltete RFID-Antenne. Die Antenne ermöglicht einen berührungslosen Datenzugriff, d.h. ein berührungsloses, automatisiertes Einschreiben bzw. Codieren und/oder Auslesen von (Personalisierungs- oder Herkunfts-)Daten in den/aus dem Halbleiterchip des Transponders.

### Stand der Technik

Es sind bereits unterschiedliche Vorrichtungen zur Fertigung von RFID-Transpondern bekannt. Zum Beispiel sind Vorrichtungen bekannt, die Antennendrähte, welche zum Beispiel von Drahtspulen abgerollt werden, an verschiedenen Bearbeitungsstationen vorbeiführen. Während des Vorbeiführens werden die Antennendrähte in der Regel unter einer Materialspannung gehalten, da sich nur straff gespannte Drähte mit der erforderlichen Fertigungsgenauigkeit ausrichten lassen und nur solche straff gespannten Drähte während der Bearbeitung die erforderliche Positionsbeständigkeit aufweisen. Die Bearbeitungsstationen, zum Beispiel Bestückungs-, Löt,- oder Versiegelungsstationen fertigen hierbei sukzessive eine quasi-endlose Folge von RFID-Transpondern, welche durch ein anschließendes Durchtrennen der Antennendrähte voneinander getrennt und anschließend weiterverarbeitet werden können.

Ein Nachteil hierbei ist jedoch, dass in der Regel eine Vielzahl von einzelnen Bearbeitungsstationen nötig ist, sodass die Antennendrähte - sollen diese nacheinander an den Bearbeitungsstationen nötig ist, sodass die Antennendrähte - sollen diese nacheinander an den Bearbeitungsstationen vorbeigeführt werden - üblicherweise über eine Distanz von mehreren Metern gespannt werden müssen. Gleichzeitig ist jedoch die maximale auf die Antennendrähte, welche naturgemäß einen beschränkten Durchmesser aufweisen, ausübbare Spannkraft begrenzt, da sonst die Antennendrähte während der Herstellung reißen würden. Somit ist die maximale Distanz, über die die Antennendrähte aufgespannt werden können ohne zu reißen und gleichzeitig die erforderliche Ausrichtungsgenauigkeit und Positionsbeständigkeit für eine Transponderfertigung aufweisen, begrenzt.

Da zudem jede Bearbeitungsstation eine bestimmte räumliche Breite bzw. Länge entlang der gespannten Drähte aufweist, ist die maximale Anzahl der Fertigungsstationen - und somit auch der Fertigungsschritte - durch die maximale auf die Antennendrähte der RFID-Transponder ausübbare Spannkraft begrenzt.

Vorrichtungen und Verfahren zur Fertigung von RFID-Transpondern mit zwei Antennendrähten, zwischen denen jeweils ein RFID-Chip angeordnet wird, werden zum Beispiel durch die Dokumente EP 1 816 592 A1 und WO 2008 / 037 592 A1 offenbart.

### Technisches Problem

Es besteht somit weiter Bedarf an einer verbesserten Vorrichtung und an einem verbesserten Verfahren zur Fertigung von RFID-Transpondern, welche insbesondere die Anordnung einer Vielzahl von einzelnen Bearbeitungsstationen entlang eines Förderweges ermöglichen.

### Lösung

Das technische Problem wird jeweils durch die Gegenstände der unabhängigen Ansprüche gelöst. Vorteilhafte Ausgestaltungen sind durch die abhängigen Ansprüche definiert.

Nach einem ersten Aspekt werden eine Vorrichtung und ein Verfahren mit einer Gleitfläche vorgeschlagen.

Eine Vorrichtung zur Herstellung von RFID-Transpondern weist zumindest eine Gleitfläche und eine Drahtfördervorrichtung auf, die dazu angeordnet und ausgebildet ist, zumindest zwei Antennendrähte in einer Förderrichtung zu fördern, wobei die Antennendrähte hierbei zumindest abschnittsweise zueinander parallel angeordnet sind. Zumindest eine Bestückungsvorrichtung ist dazu angeordnet und ausgebildet, einen Transponderchip zwischen den parallel angeordneten Antennendrähten anzuordnen bzw. zu platzieren.

Insbesondere kann die Bestückungsvorrichtung dazu angeordnet und ausgebildet sein, einen Transponderchip zwischen den parallel angeordneten Antennendrähten derart anzuordnen/zu positionieren, dass eine elektrisch leitende Verbindung zwischen den Antennendrähten und dem Transponderchip, insbesondere mit Anschlusskontakten des Transponderchips, hergestellt wird.

Die Drahtfördervorrichtung ist ferner dazu angeordnet und ausgebildet, die Antennendrähte zumindest abschnittsweise über die Gleitfläche hinweg zu fördern und die Antennendrähte im Zusammenwirken mit der Gleitfläche zu spannen, sodass die Antennendrähte eine Materialspannung längs der Förderrichtung aufweisen.

Ein Spannen eines Antennendrahtes im Sinne der Erfindung bezeichnet hierbei das Ausüben einer Kraft und/oder das Hervorrufen bzw. Bewirken einer Materialspannung längs der Längenrichtung bzw. Dochtlinie eines Antennendrahtes. Mit anderen Worten ist ein Antennendraht dann gespannt, wenn eine Kraft parallel zu seiner Längenausdehnung wirkt, sodass eine Materialspannung in dem Antennendraht besteht, welche zumindest nicht vollständig durch eine Deformation des Antennendrahts ausgeglichen werden kann, und der Antennendraht in der Richtung der wirkenden Kraft ausgerichtet ist.

Ein Vorteil dieser Vorrichtung ist es, das die Distanz, über die ein Antennendraht gespannt und an verschiedenen Bearbeitungsstationen vorbei gefördert werden kann, gegenüber bekannten Vorrichtungen vergrößert ist, ohne das hierzu eine von einer Drahtfördervorrichtung auf den Antennendraht ausgeübte Spannkraft erhöht werden müsste. Die Gleitfläche, über die der Antennendraht gefördert wird, ermöglicht es, die Antennendrähte über eine vergrößerte Distanz straff gespannt zu halten und/oder zu fördern, ohne dass hierbei auf einen einzelnen Abschnitt der Antennendrähte eine Kraft wirkt, die dessen Zerstörung bewirken würde.

Die Gleitfläche kann zumindest teilweise konvex geformt sein, wobei die konvexe Krümmung zumindest im Wesentlichen in Richtung der Förderrichtung ausgeformt ist. Zumindest ein der den Antennendrähten zugewandter Teil der Gleitfläche kann mit einer Beschichtung, zum Beispiel mit einer Polytetrafluorethylenbeschichtung, ausgebildet sein.

Ferner kann die Vorrichtung zumindest eine Unterlagenfördervorrichtung aufweisen, die dazu angeordnet und ausgebildet ist, eine Verarbeitungsunterlage, insbesondere ein Silikonpapier, in der Förderrichtung über die Gleitfläche zu fördern.

Ein Vorteil hierbei ist, dass die Antennendrähte nicht unmittelbar in Anlage mit der Gleitfläche sondern auf der Verarbeitungsunterlage gefördert werden können. Hierdurch wird zum Beispiel eine Verschmutzung der Gleitfläche während der Fertigung der RFID-Transponder vermieden.

Die Unterlagenfördervorrichtung kann ferner dazu angeordnet und ausgebildet sein, die Verarbeitungsunterlage im Zusammenwirken mit der Gleitfläche zu spannen.

Ein Spannen der Verarbeitungsunterlage im Sinne der Erfindung bezeichnet hierbei das Ausüben einer Kraft und/oder das Hervorrufen bzw. Bewirken einer Materialspannung längs der Längenrichtung einer insbesondere streifenförmigen Verarbeitungsunterlage, welche insbesondere ein Silikonpapier sein kann. Mit anderen Worten ist eine Verarbeitungsunterlage dann gespannt, wenn eine Kraft parallel zu ihrer Längenausdehnung wirkt, sodass eine Materialspannung in der Verarbeitungsunterlage besteht, welche zumindest nicht vollständig durch eine Deformation der Verarbeitungsunterlage ausgeglichen werden kann, und die Verarbeitungsunterlage in der Richtung der wirkenden Kraft ausgerichtet ist.

Weiter kann die Unterlagenfördervorrichtung die Verarbeitungsunterlage in derselben Fördergeschwindigkeit fördern, in der die Drahtfördervorrichtung die Antennendrähte fördert, sodass zwischen der Verarbeitungsunterlage und den Antennendrähten keine Relativbewegung und/oder Relativgeschwindigkeit auftritt.

Ein Vorteil hierbei ist, dass keine oder nur wenig Reibung zwischen den Antennendrähten und der Verarbeitungsunterlage auftritt, sodass einem ungewollten/unbeabsichtigten Verschieben und/oder einer ungewollten/ unbeabsichtigten Positionsveränderung der Antennendrähte aufgrund einer Reibung der Antennendrähte auf der Gleitunterlage entgegengewirkt werden kann.

Die Unterlagenfördervorrichtung kann die Verarbeitungsunterlage taktweise fördern. Ebenso kann die Drahtfördervorrichtung die Antennendrähte taktweise fördern. Ein Vorteil hierbei ist, dass die Antennendrähte und/oder die Verarbeitungsunterlage während einer Fertigung bzw. Bearbeitung durch eine Fertigungsstation, zum Beispiel während der Anordnung eines Transponderchips durch eine Bestückungsvorrichtung, in einer Ruhelage sind. Mit anderen Worten ermöglicht ein taktweises Fördern der Antennendrähte und/oder der Verarbeitungsunterlage, dass die Antennendrähte und/oder die Verarbeitungsunterlage während einer Fertigung bzw. Bearbeitung durch eine Fertigungsstation keine Relativbewegung und/oder Relativgeschwindigkeit in der Förderrichtung zu der jeweiligen Fertigungsstation aufweisen.

Die Unterlagenfördervorrichtung kann zudem dazu angeordnet und ausgebildet sein, die Verarbeitungsunterlage in Anlage mit der Gleitfläche anzuordnen und die Verarbeitungsunterlage mit einer Gleitreibung über die Gleitfläche zu fördern.

Die Drahtfördervorrichtung kann dazu angeordnet und ausgebildet sein, die Antennendrähte zumindest abschnittsweise in Anlage mit der Gleitfläche anzuordnen und die Antennendrähte mit einer Gleitreibung über die Gleitfläche zu fördern.

Alternativ kann die Drahtfördervorrichtung dazu ausgebildet und angeordnet sein, die Antennendrähte zumindest abschnittsweise in Anlage mit der Verarbeitungsunterlage anzuordnen.

In einer Variante kann die Drahtfördervorrichtung eine oder mehrere Bereitstellungsrollen und/oder eine oder mehrere Umlenkrollen und/oder eine Aufnahmerolle aufweisen.

Ferner kann die Unterlagenfördervorrichtung eine Unterlagenbereitstellungsrolle und/oder eine oder mehrere Umlenkrollen und/oder eine Unterlagenaufnahmerolle aufweisen.

Ein Vorteil hierbei ist, dass die Antennendrähte und/oder die Gleitunterlage jeweils als quasi-endlose Fertigungsmaterialien bereitgestellt werden können, sodass die Effizienz einer Fertigung von großen Stückzahlen von RFID-Transpondern befördert wird.

Die Gleitfläche kann sich über mindestens 25%, insbesondere über mindestens 50%, des Förderweges der Antennendrähte ausdehnen, sodass die Antennendrähte über mindestens 25%, insbesondere über mindestens 50%, des gesamten Förderweges - von der/den Bereitstellungsrolle/n bis hin zur Aufnahmerolle - in Anlage mit der Gleitfläche oder in Anlage mit einer über die Gleitfläche geförderten Verarbeitungsunterlage angeordnet sind.

In einer Variante kann die Bestückungsvorrichtung dazu angeordnet und ausgebildet sein, einen Abstand der zumindest abschnittsweise zueinander parallelen Antennendrähte temporär lokal zu verändern, sodass die Antennendrähte im Bereich der Bestückungsvorrichtung temporär einen Bestückungsabstand zueinander aufweisen, der größer ist als der Abstand der Antennendrähte außerhalb des Bereichs der Bestückungsvorrichtung. Hierdurch können insbesondere in einem Querschnitt T-förmige Transponderchips und/oder Transponderchips mit einer seitlichen Vertiefung zur Aufnahme von Antennendrähten zwischen den parallelen Antennendrähten angeordnet werden.

Mit anderen Worten ist die Bestückungsvorrichtung dazu angeordnet und ausgebildet, den Abstand zwischen den zumindest zwei Antennendrähten in einem vorbestimmten Bereich bzw. Drahtabschnitt vorübergehend zu vergrößern, sodass das Anordnen eines Transponderchips zwischen den Antennendrähten ermöglicht oder zumindest erleichtert wird. Anschlie-βend, nach dem Positionieren des Transponderchips in einem von den Antennendrähten umgebenen Zwischenraum, kann die Bestückungsvorrichtung den Abstand zwischen den Antennendrähten wieder auf den ursprünglichen Abstand reduzieren, sodass die Antennendrähte vorzugsweise jeweils in Anlage mit dem zwischen ihnen positionierten Transponderchip angeordnet sind.

Weiter kann die Bestückungsvorrichtung ein oder mehrere Abstandsveränderungselement/e, insbesondere Abstandsstifte, aufweisen, die jeweils in einer Richtung und in einer der Richtung entgegengesetzten Gegenrichtung beweglich sind, wobei die Richtung und die Gegenrichtung jeweils winklig, insbesondere orthogonal, zur Förderrichtung und orthogonal zur Flächennormalen einer durch die zumindest abschnittsweise zueinander parallelen Antennendrähte verlaufenden Ebene verlaufen.

Ferner können die Abstandsveränderungselemente parallel zu einer Flächennormalen einer durch die zumindest abschnittsweise zueinander parallelen Antennendrähte verlaufenden Ebene absenkbar und anhebbar sein, wobei die Abstandsveränderungselemente in einem abgesenkten Zustand zwischen den Antennendrähten angeordnet sind und in einem angehobenen Zustand nicht zwischen den geförderten Antennendrähten angeordnet sind.

Mit anderen Worten kann die Bestückungsvorrichtung Abstandsstifte, insbesondere Paare von Abstandsstiften aufweisen, die aus einer Ruheposition in einen Bereich zwischen die Antennendrähte hinein abgesenkt werden können und anschließend durch eine Bewegung winklig zur Förderrichtung der Drähte in Anlage mit den Drähten gebracht werden können. Weiter können die Abstandsstifte durch eine weitere Bewegung winklig zur Förderrichtung die Position der Antennendrähte, welche sich nun in Anlage mit den Abstandsstiften befinden, so verändern, dass sich ein Abstand der Antennendrähte zueinander, zumindest in einem Bereich der Abstandsstifte, erhöht. Hierbei kann sich die Materialspannung der Antennendrähte ebenfalls temporär erhöhen. Nachdem der Transponderchip durch die Bestückungsvorrichtung zwischen den Antennendrähten positioniert/angeordnet ist, können sich die Abstandsstifte entgegen der Bewegung zur Vergrößerung des Abstands zurückbewegen, sodass sich der Abstand der Antennendrähte wieder verringert. Sobald sich die Abstandsstifte wieder zwischen den Antennendrähten befinden und/oder sich nicht weiter in Anlage mit den Antennendrähten befinden, können die Abstandsstifte wieder in die Ruheposition hinein angehoben werden bzw. aus dem Bereich zwischen den Antennendrähten entfernt werden, sodass ein Förderweg in der Förderrichtung für die Antennendrähte und den zwischen ihnen angeordneten Transponderchip freigegeben bzw. nicht behindert ist.

In einer Variante kann die Bestückungsvorrichtung weiter, alternativ oder ergänzend zu den Abstandsstiften, in einem Querschnitt dreieckförmige, zumindest abschnittsweise elliptische oder zumindest abschnittsweise trapezförmige Abstandsveränderungselemente in einen Bereich zwischen den zumindest abschnittsweise zueinander parallel angeordneten Antennendrähte einbringen, wobei die in einem Querschnitt dreieckförmigen, zumindest abschnittsweise elliptischen oder zumindest abschnittsweise trapezförmigen Abstandsveränderungselemente bereits durch das Absenken in den Bereich zwischen die Antennendrähte zunächst in Anlage mit diesen gelangen und durch ein weiteres Absenken einen Abstand der Antennendrähte zueinander temporär lokal vergrößern. Ein Anheben der in einem Querschnitt dreieckförmigen, zumindest abschnittsweise elliptischen oder zumindest abschnittsweise trapezförmigen Abstandsveränderungselemente beendet die temporäre Vergrößerung des Abstands der Antennendrähte.

Der Fachmann versteht hierbei, dass die Anzahl der Abstandsveränderungselemente im Grundsatz frei gewählt werden kann und dass bereits ein einziges Abstandsveränderungselement im Grundsatz ausreichend ist, um einen Abstand der Antennendrähte zueinander temporär zu verändern. Ferner versteht der Fachmann, dass ein Absenken und ein Anheben im Sinne der Erfindung zwei zueinander entgegengesetzte Bewegungsrichtungen bezeichnen, jedoch keine Position der Bestückungsvorrichtung oder Teile der Bestückungsvorrichtung in Relation zu den geförderten Antennendrähten festlegen. Insbesondere kann sich eine Ruhelage der Abstandsveränderungselemente sowohl oberhalb als auch unterhalb der geförderten Antennendrähte befinden, sodass ein Absenken stets eine Bewegung der Abstandsveränderungselemente in den Bereich zwischen den Antennendrähten hinein bezeichnet und ein Anheben stets eine Bewegung aus dem Bereich zwischen den Antennendrähten heraus bezeichnet.

In einer Weiterbildung kann die Bestückungsvorrichtung ferner Unterstützungselemente, insbesondere Unterstützungsstifte, aufweisen, die dazu angeordnet und ausgebildet sind, einen temporär lokal vergrößerten Abstand der Antennendrähte räumlich zumindest teilweise zu begrenzen. Insbesondere können die Unterstützungselemente jeweils an einer dem Bereich zwischen den Antennendrähten abgewandten (Außen-)Seite der Antennendrähte angeordnet sein. Ferner können die Unterstützungselemente von den jeweiligen Antennendrähten zumindest soweit beabstandet sein, dass ein Förderweg in der Förderrichtung für die Antennendrähte und den zwischen ihnen angeordneten Transponderchip freigegeben bzw. nicht behindert ist. In einer Weiterbildung können die Unterstützungselemente zudem in einer Richtung in einem Winkel zur Förderrichtung und in einer hierzu korrespondierenden Gegenrichtung beweglich sein. Zudem können auch die Unterstützungselemente absenkbar und/oder anhebbar sein, zum Beispiel um einen Förderweg freizugeben.

Ein Vorteil hierbei ist, dass eine Beeinträchtigung weiterer Bearbeitungsstationen bzw. Bearbeitungsschritte durch den von der Bestückungsvorrichtung temporär veränderten Abstand der Antennendrähte reduziert werden kann.

Weiter kann die Vorrichtung zur Herstellung von RFID-Transpondern einen Flussmittelspender aufweisen der dazu angeordnet und ausgebildet ist, jeweils einen Flussmittelauftrag, der ein Verlöten der Antennendrähte mit einem Transponderchip erleichtert, auf die Antennendrähte aufzutragen.

Ferner kann eine Lötvorrichtung, dazu angeordnet und ausgebildet sein, jeweils ein Lot auf die zumindest abschnittsweise zueinander parallelen Antennendrähte und/oder auf einen Transponderchip bzw. auf einen Teil eines Transponderchips aufzubringen und die zumindest abschnittsweise zueinander parallelen Antennendrähte mit einem zwischen ihnen angeordneten Transponderchip zu verlöten; insbesondere kann die Lötvorrichtung gemeinsam bzw. als gemeinsame Baugruppe mit der Bestückungsvorrichtung ausgebildet sein.

Eine Verbindungsvorrichtung kann dazu angeordnet und ausgebildet sein, eine elektrisch leitende Verbindung zwischen den Antennendrähten herzustellen. Hierzu kann zum Beispiel eine elektrisch leitende Verbindung durch einen elektrisch leitenden Materialauftrag, welcher zum Beispiel eine Silberverbindung oder eine silberhaltige Verbindungssubstanz sein kann, zwischen den zumindest abschnittsweise zueinander parallelen Antennendrähten hergestellt werden. Optional kann die Verbindungsvorrichtung weiter eine Vorrichtung zur Trocknung/Antrocknung eines aufgebrachten Materialauftrags aufweisen, zum Beispiel eine Heißlufttrocknungsvorrichtung. Alternativ können die Antennendrähte zum Beispiel auch miteinander verlötet werden oder es kann ein elektrisch leitendes Verbindungselement zwischen die Antennendrähte angeordnet und mit diesen elektrisch leitend verbunden, insbesondere verlötet werden.

Weiter kann eine Isolationsvorrichtung dazu angeordnet und ausgebildet sein, zumindest einen Teil der Antennendrähte und/oder zumindest einen Teil der elektrisch leitenden Verbindung mit einem Isolationsmaterial zu umgeben. Dieses kann zum Beispiel durch einen dielektrischen Materialauftrag, insbesondere durch eine Isolationslackierung, geschehen. In einer Weiterbildung kann die Isolationsvorrichtung zudem eine UV-Bestrahlungsvorrichtung umfassen, die dazu angeordnet ist, einen durch die Isolationsvorrichtung aufgebrachten Materialauftrag, insbesondere eine Isolationslackierung, mittels UV-Licht anzutrocknen und/oder auszuhärten.

Eine Trennvorrichtung, insbesondere eine Laser-Trennvorrichtung kann dazu angeordnet und ausgebildet sein, zumindest einen der Antennendrähte und/oder zumindest einen Teil des Isolationsmaterials zu durchtrennen/perforieren/unterbrechen. Hierdurch kann eine Länge einer Antenne einer zu fertigenden Transponderanordnung eingestellt bzw. hergestellt werden. Insbesondere können offene bzw. nicht zu einer Schleife geformte Enden einer Antenne gleichlang oder unterschiedlich lang hergestellt werden.

Zusätzlich kann eine Versiegelungsvorrichtung dazu angeordnet und ausgebildet sein, eine Versiegelung zumindest auf einen Teil des Transponderchips und/oder auf das Isolationsmaterial und/oder auf die Antennendrähte aufzutragen. Die Versiegelung kann insbesondere ein mittels UV-Licht aushärtbarer Materialauftrag sein. Hierzu kann auch die Versiegelungsvorrichtung eine UV-Bestrahlungsvorrichtung umfassen, die dazu angeordnet und ausgebildet ist, einen durch die Versiegelungsvorrichtung aufgebrachten Materialauftrag mittels UV-Licht anzutrocknen und/oder auszuhärten.

Weiter kann die Vorrichtung zur Herstellung von RFID-Transpondern eine Inspektionsvorrichtung umfassen, die dazu angeordnet und ausgebildet ist, Eigenschafts- und/oder Positionierungsfehler eines Transponderchips und/oder einer Transponderanordnung zu ermitteln. Eine Transponderanordnung bezeichnet hierbei eine Anordnung umfassend einen Transponderchip und zumindest jeweils einen Abschnitt von zumindest zwei Antennendrähten und/oder eine Verbindung und/oder ein Isolationsmaterial und/oder eine Versiegelung. Die Inspektionsvorrichtung kann zum Beispiel optisch erfassende Sensoren, insbesondere eine Kameraanordnung, aufweisen, die dazu geeignet ist Lage- bzw. Positionierungsfehler einer Transponderanordnung und/oder eines Teils der Transponderanordnung zu ermitteln und/oder optisch erkennbare Eigenschaftsfehler der Transponderanordnung und/oder eines Teils der Transponderanordnung zu ermitteln. In einer Weiterbildung kann die Inspektionsvorrichtung auch eine Vorrichtung zum Auslesen von RFID-Transpondern umfassen, die dazu angeordnet und ausgebildet ist, eine Transponderanordnung/einen RFID-Transponder auf Funktionsfähigkeit zu überprüfen. Ferner kann die Inspektionsvorrichtung eine Schreibvorrichtung aufweisen, die dazu angeordnet und ausgebildet ist, eine Transponderanordnung/einen RFID-Transponder zu Codieren bzw. Daten an eine Transponderanordnung/einen RFID-Transponder zu übertragen. Optional kann die Schreibvorrichtung gemeinsam mit der Vorrichtung zum Codieren und/oder Auslesen von RFID-Transpondern ausgebildet sein.

In einer Variante kann die Transponderanordnung weiter eine Vereinzelungsvorrichtung aufweisen, die dazu angeordnet und ausgebildet ist, die Antennendrähte und/oder das Isolationsmaterial jeweils zu durchtrennen, sodass jeweils eine vereinzelte Transponderanordnung mit zumindest einem Transponderchip und zumindest einer Antennenanordnung, insbesondere einer Schleifenantenne, entsteht/hergestellt wird, wobei die Antennenanordnung der Transponderanordnung zumindest einen Abschnitt der durchtrennten Antennendrähte und/oder der elektrisch leitenden Verbindung umfasst.

Ein Verfahren zur Herstellung von RFID-Transpondern weist die folgenden Schritte auf:
- Bereitstellen von zumindest zwei Antennendrähten, die von einer Drahtfördervorrichtung zumindest abschnittsweise zueinander parallel in einer Förderrichtung über eine Gleitfläche gefördert werden, wobei die Antennendrähte von der Drahtfördervorrichtung im Zusammenwirken mit der Gleitfläche gespannt werden, sodass die Antennendrähte eine Materialspannung längs der Förderrichtung aufweisen;
- Anordnen eines Transponderchips zwischen die zumindest abschnittsweise zueinander parallel in der Förderrichtung geförderten Antennendrähte.

Optional kann das Verfahren zudem einen oder mehrere der folgenden Schritte aufweisen:
- Auftragen eines Flussmittelauftrags auf die Antennendrähte; und/oder
- Aufbringen eines Lots auf die Antennendrähte und/oder auf einen Transponderchip und Verlöten der zumindest abschnittsweise zueinander parallelen Antennendrähte mit einem zwischen den Antennendrähten angeordneten Transponderchip; und/oder
- Herstellen zumindest einer elektrisch leitenden Verbindung zwischen den zumindest zwei Antennendrähten; und/oder
- Umgeben zumindest eines Teils der Antennendrähte und/oder zumindest eines Teils der elektrisch leitenden Verbindung mit einem Isolationsmaterial; und/oder
- Durchtrennen zumindest eines Teils der Antennendrähte und/oder zumindest eines Teils des Isolationsmaterials; und/oder
- Auftragen einer Versiegelung zumindest auf einen Teil des Transponderchips und/oder auf das Isolationsmaterial und/oder auf die Antennendrähte; und/oder
- Ermitteln von Eigenschafts- und/oder Positionierungsfehlern eines Transponderchips und/oder einer Transponderanordnung.

Nach einem zweiten Aspekt werden eine Vorrichtung und ein Verfahren mit winklig zur Förderrichtung aufgespannten Antennendrähten vorgeschlagen.

Eine Vorrichtung zur Herstellung von RFID-Transpondern weist eine Drahtfördervorrichtung mit zumindest zwei Drahtfördereinheiten auf, die dazu angeordnet und ausgebildet sind, zumindest zwei Antennendrähte in einer Förderrichtung zu fördern. Die Drahtfördereinheiten sind weiter dazu angeordnet und ausgebildet, im Zusammenwirken die zumindest zwei Antennendrähte zueinander zumindest abschnittsweise parallel in einem Winkel, insbesondere in einem Winkel von im Wesentlichen 90°, zur Förderrichtung zu spannen, sodass die abschnittsweise zueinander parallelen Antennendrähte eine Materialspannung in einem Winkel, insbesondere in einem Winkel von im Wesentlichen 90°, zur Förderrichtung aufweisen. Zumindest eine Bestückungsvorrichtung ist dazu angeordnet und ausgebildet, einen Transponderchip zwischen den in einem Winkel, insbesondere in einem Winkel von im Wesentlichen 90°, zur Förderrichtung gespannten Antennendrähten bzw. Antennendrahtabschnitten anzuordnen.

Die Drahtfördereinheiten können insbesondere dazu angeordnet und ausgebildet sein, die zumindest zwei Antennendrähte derart aufzunehmen und/oder zu fördern, dass eine Vielzahl von einzelnen Abschnitten der Antennendrähte jeweils zueinander parallel und in einem Winkel, insbesondere in einem Winkel von im Wesentlichen 90°, zur Förderrichtung gespannt/aufgespannt sind. Hierbei können insbesondere jeweils ein Abschnitt eines ersten der zumindest zwei Antennendrähte und ein Abschnitt eines zweiten der zumindest zwei Antennendrähte benachbart und zumindest abschnittsweise parallel zueinander angeordnet/ gespannt/aufgespannt sein.

Mit anderen Worten kann die Vorrichtung zur Herstellung von RFID-Transpondern zumindest zwei Antennendrähte in einer Förderrichtung fördern, wobei jeweils eine Vielzahl einzelner Abschnitte der geförderten Drähte jeweils parallel zueinander und gleichzeitig in einem Winkel zur Förderrichtung angeordnet ist.

Ein Spannen eines Antennendrahtes im Sinne der Erfindung bezeichnet hierbei das Ausüben einer Kraft und/oder das Hervorrufen bzw. Bewirken einer Materialspannung längs der Längenrichtung bzw. Dochtlinie zumindest eines Abschnitts eines Antennendrahtes. Mit anderen Worten ist ein Abschnitt eines Antennendrahtes dann gespannt, wenn eine Kraft parallel zu seiner Längenausdehnung wirkt, sodass eine Materialspannung in dem Antennendrahtabschnitt besteht, welche zumindest nicht vollständig durch eine Deformation des Antennendrahts ausgeglichen werden kann, und der Antennendrahtabschnitt in der Richtung der wirkenden Kraft ausgerichtet ist.

Ein Vorteil dieser Vorrichtung ist es, dass zumindest ein Paar von Antennendrähten jeweils Abschnittsweise gespannt/aufgespannt und an verschiedenen Bearbeitungsstationen vorbei gefördert werden kann, wobei der jeweils gespannte Abschnitt deutlich kleiner sein kann als eine Länge des (Gesamt-)Förderwegs. Somit ist lediglich eine begrenzte Spannkraft zum spannen der Antennendrähte notwendig, welche zudem nicht von der Länge des Förderwegs der Vorrichtung abhängig ist. Hierdurch lässt sich - zumindest theoretisch - ein Förderweg beliebiger Länge und mit beliebig vielen Bearbeitungsstationen bzw. Bearbeitungsschritten implementieren, ohne dass hierzu die Spannkraft, welche auf die Abschnitte des Antennendrahtes auszuüben ist, erhöht werden müsste.

Die Drahtfördereinheiten können gemeinsam einen Innenraum umformen. Insbesondere können die Antennendrähte bzw. die in einem Winkel zur Förderrichtung gespannten Abschnitte der Antennendrähte den durch die Drahtfördereinheiten umformten Innenraum überspannen/queren.

Ein Abstand der Drahtfördereinheiten zueinander kann veränderbar sein. Hierdurch kann eine Position der Drahtfördereinheiten justiert werden und/oder eine auf die in einem Winkel zur Förderrichtung gespannten Abschnitte der Antennendrähte ausgeübte Spannkraft hervorgerufen und/oder eingestellt werden.

Die Drahtfördereinheiten können zum Beispiel als in der Förderrichtung umlaufende, insbesondere quasi-endlose, Fördervorrichtungen, insbesondere als in der Förderrichtung umlaufende Förderbänder oder als in der Förderrichtung umlaufende Förderketten, ausgestaltet sein.

In einer Variante können die Drahtfördereinheiten eine Vielzahl von Antennendrahtaufnehmern und/oder eine Vielzahl von Antennendrahtaufnehmerpaaren aufweisen. Die Antennendrahtaufnehmer können Haken, Ösen, Stifte, Rollen und/oder Umlenkelemente umfassen. Insbesondere können die Antennendrahtaufnehmer in einem Winkel von 90° zur Förderrichtung und in einem Winkel von 90° zu den abschnittsweise zueinander parallelen Antennendrähten von den Drahtfördereinheiten, zum Beispiel von einer Förderkette, abstehen.

Die Antennendrahtaufnehmer und/oder die Antennendrahtaufnehmerpaare können jeweils in einem regelmäßigen Abstand zueinander an den Drahtfördereinheiten angeordnet sein.

Ferner können die Antennendrahtaufnehmer und/oder die Antennendrahtaufnehmerpaare jeweils dazu angeordnet und ausgebildet sein, jeweils mit einem Antennendraht in Anlage gebracht zu werden, wobei der Antennendraht eine Materialspannung aufweist, und/oder die Antennendrahtaufnehmer und/oder die Antennendrahtaufnehmerpaare können dazu angeordnet und ausgebildet sein, jeweils im Zusammenwirken einen Abschnitt der Antennendrähte, welcher zwischen den Antennendrahtaufnehmern/ Antennendrahtaufnehmerpaaren angeordnet ist, zu spannen, sodass der Abschnitt der Antennendrähte jeweils eine Materialspannung aufweist.

In einer Variante kann die Drahtfördervorrichtung eine oder mehrere Bereitstellungsrollen und/oder eine oder mehrere Umlenkrollen und/oder eine Aufnahmerolle aufweisen.

In einer Variante kann die Vorrichtung zur Herstellung von RFID-Transpondern eine Verlegevorrichtung aufweisen, die dazu angeordnet und ausgebildet ist, die zumindest zwei Antennendrähte jeweils mit einem Antennendrahtaufnehmer einer Drahtfördereinheit und/oder mit einem Antennendrahtaufnehmerpaar einer Drahtfördereinheit in Anlage zu bringen/anzuordnen, sodass die Antennendrähte zwischen zwei jeweils voneinander beabstandeten Antennendrahtaufnehmern oder Antennendrahtaufnehmerpaaren eine Materialspannung aufweisen.

Die Verlegevorrichtung kann hierzu insbesondere zumindest zwei Verlegearme aufweisen, die jeweils dazu angeordnet und ausgebildet sind, jeweils einen der zumindest zwei Antennendrähte, die zum Beispiel von einer Bereitstellungsrolle als quasi-endloser Antennendraht abgerollt werden, aufzunehmen und jeweils abwechselnd mit jeweils einem Aufnehmer einer ersten und einer zweiten Drahtfördervorrichtung in Anlage zu bringen/anzuordnen, wobei der angeordnete bzw. in Anlage gebrachte Antennendraht hierbei zwischen den Aufnehmern gespannt ist, sodass der zwischen den Aufnehmern angeordnete Abschnitt des jeweiligen Antennendrahtes eine Materialspannung in einem Winkel, insbesondere in einem Winkel von im Wesentlichen 90°, zur Förderrichtung aufweist.

Weiter kann die Vorrichtung zur Herstellung von RFID-Transpondern auch zumindest eine Ablösevorrichtung umfassen, die dazu angeordnet und ausgebildet ist, zumindest einen von den zumindest zwei Drahtfördereinheiten geförderten Antennendraht von den Drahtfördereinheiten bzw. von den Aufnehmern der Drahtfördereinheiten abzulösen.

In einer Weiterbildung kann die Vorrichtung zur Herstellung von RFID-Transpondern zudem eine, insbesondere zumindest teilweise konvexe, Gleitfläche aufweisen, wobei die Drahtfördereinheiten ferner dazu angeordnet und ausgebildet sind, die zumindest abschnittsweise zueinander parallelen Antennendrähte zumindest abschnittsweise über die Gleitfläche hinweg zu fördern und die Antennendrähte im Zusammenwirken mit der Gleitfläche zu spannen, sodass die Antennendrähte eine Materialspannung in einem Winkel, insbesondere in einem Winkel von im Wesentlichen 90°, zur Förderrichtung aufweisen.

Ein Vorteil der Gleitfläche ist es, dass eine Spannung der Antennendrähte bzw. der einzelnen Abschnitte der Antennendrähte jeweils befördert wird, wobei eine auf die Antennendrähte bzw. die einzelnen Abschnitte der Antennendrähte ausgeübte Spannkraft reduziert werden kann.

Weiter kann die Vorrichtung zur Herstellung von RFID-Transpondern zumindest eine Unterlagenfördervorrichtung aufweisen, die dazu angeordnet und ausgebildet ist, eine Verarbeitungsunterlage, insbesondere ein Silikonpapier, in der Förderrichtung über die Gleitfläche zu fördern. Die Unterlagenfördervorrichtung kann eine Unterlagenbereitstellungsrolle und/oder eine oder mehrere Umlenkrollen und/oder eine Unterlagenaufnahmerolle aufweisen.

Ein Vorteil hierbei ist, dass die Antennendrähte nicht unmittelbar in Anlage mit der Gleitfläche sondern auf der Verarbeitungsunterlage gefördert werden können. Hierdurch wird zum Beispiel eine Verschmutzung der Gleitfläche während der Fertigung der RFID-Transponder vermieden.

Die Unterlagenfördervorrichtung kann ferner dazu angeordnet und ausgebildet sein, die Verarbeitungsunterlage im Zusammenwirken mit der Gleitfläche zu spannen, sodass die Verarbeitungsunterlage eine Materialspannung in der Förderrichtung aufweist.

Ein Spannen der Verarbeitungsunterlage im Sinne der Erfindung bezeichnet hierbei das Ausüben einer Kraft und/oder das Hervorrufen bzw. Bewirken einer Materialspannung längs der Längenrichtung einer insbesondere streifenförmigen Verarbeitungsunterlage, welche insbesondere ein Silikonpapier sein kann. Mit anderen Worten ist eine Verarbeitungsunterlage dann gespannt, wenn eine Kraft parallel zu ihrer Längenausdehnung wirkt, sodass eine Materialspannung in der Verarbeitungsunterlage besteht, welche zumindest nicht vollständig durch eine Deformation der Verarbeitungsunterlage ausgeglichen werden kann, und die Verarbeitungsunterlage in der Richtung der wirkenden Kraft ausgerichtet ist.

Weiter kann die Unterlagenfördervorrichtung die Verarbeitungsunterlage in derselben Fördergeschwindigkeit fördern, in der die Drahtfördervorrichtung bzw. die Drahtfördereinheiten die Antennendrähte fördern, sodass zwischen der Verarbeitungsunterlage und den Antennendrähten keine Relativbewegung/Relativgeschwindigkeit auftritt.

Ein Vorteil hierbei ist, dass keine oder nur wenig Reibung zwischen den Antennendrähten und der Verarbeitungsunterlage auftritt, sodass einem ungewollten/unbeabsichtigten Verschieben und/oder einer ungewollten/unbeabsichtigten Positionsveränderung der Antennendrähte aufgrund einer Reibung der Antennendrähte auf der Gleitunterlage entgegengewirkt werden kann.

Die Unterlagenfördervorrichtung kann die Verarbeitungsunterlage taktweise fördern. Ebenso können die Drahtfördervorrichtung bzw. die Drahtfördereinheiten die Antennendrähte taktweise fördern. Ein Vorteil hierbei ist, dass sich die Antennendrähte und/oder die Verarbeitungsunterlage während einer Fertigung bzw. Bearbeitung durch eine Fertigungsstation, zum Beispiel während der Anordnung eines Transponderchips durch eine Bestückungsvorrichtung, in einer Ruhelage befinden. Mit anderen Worten ermöglicht ein taktweises Fördern der Antennendrähte und/oder der Verarbeitungsunterlage, dass die Antennendrähte und/oder die Verarbeitungsunterlage während einer Fertigung bzw. Bearbeitung durch eine Fertigungsstation keine Relativbewegung/Relativgeschwindigkeit in der Förderrichtung zu der jeweiligen Fertigungsstation aufweisen.

Die Unterlagenfördervorrichtung kann zudem dazu angeordnet und ausgebildet sein, die Verarbeitungsunterlage in Anlage mit der Gleitfläche anzuordnen und die Verarbeitungsunterlage mit einer Gleitreibung über die Gleitfläche zu fördern.

Die Drahtfördervorrichtung bzw. die Drahtfördereinheiten können dazu angeordnet und ausgebildet sein, die Antennendrähte zumindest abschnittsweise in Anlage mit der Gleitfläche anzuordnen und die Antennendrähte mit einer Gleitreibung über die Gleitfläche zu fördern.

Alternativ können die Drahtfördervorrichtung bzw. die Drahtfördereinheiten dazu ausgebildet und angeordnet sein, die Antennendrähte zumindest abschnittsweise in Anlage mit der Verarbeitungsunterlage anzuordnen.

Ferner kann die Unterlagenfördervorrichtung eine Unterlagenbereitstellungsrolle und/oder eine oder mehrere Umlenkrollen und/oder eine Unterlagenaufnahmerolle aufweisen.

Ein Vorteil hierbei ist, dass die Gleitunterlage als quasi-endloses Fertigungsmaterial bereitgestellt werden kann, sodass die Effizienz einer Fertigung von großen Stückzahlen von RFID-Transpondern befördert wird.

In einer Variante kann die Bestückungsvorrichtung dazu angeordnet und ausgebildet sein, einen Abstand von zueinander parallelen Antennendrahtabschnitten temporär lokal zu verändern, sodass die Antennendrahtabschnitte im Bereich der Bestückungsvorrichtung temporär einen Bestückungsabstand zueinander aufweisen, der größer ist als der Abstand der Antennendrahtabschnitte außerhalb des Bereichs der Bestückungsvorrichtung. Hierdurch können insbesondere in einem Querschnitt T-förmige Transponderchips und/oder Transponderchips mit einer seitlichen Vertiefung zur Aufnahme von Antennendrähten zwischen den parallelen Antennendrahtabschnitten angeordnet werden.

Mit anderen Worten ist die Bestückungsvorrichtung dazu angeordnet und ausgebildet, den Abstand zwischen den zwei Antennendrähten in einem vorbestimmten Bereich bzw. Drahtabschnitt vorübergehend zu vergrößern, sodass das Anordnen eines Transponderchips zwischen den Antennendrähten ermöglicht oder zumindest erleichtert wird. Anschließend, nach dem Positionieren des Transponderchips in einem von den Antennendrahtabschnitten umgebenen Zwischenraum, kann die Bestückungsvorrichtung den Abstand zwischen den Antennendrahtabschnitten wieder auf den ursprünglichen Abstand reduzieren, sodass die Antennendrahtabschnitte vorzugsweise jeweils in Anlage mit dem zwischen ihnen positionierten Transponderchip angeordnet sind.

Weiter kann die Bestückungsvorrichtung ein oder mehrere Abstandsveränderungselement/e, insbesondere Abstandsstifte, aufweisen, die jeweils in einer Richtung und in einer der Richtung entgegengesetzten Gegenrichtung beweglich sind, wobei die Richtung und die Gegenrichtung zum Beispiel parallel zu Förderrichtung und orthogonal zur Flächennormalen einer durch die zumindest parallelen Antennendrahtabschnitte verlaufenden Ebene verlaufen.

Ferner können die Abstandsveränderungselemente parallel zu einer Flächennormalen einer durch die zumindest abschnittsweise zueinander parallelen Antennendrähte verlaufenden Ebene absenkbar und anhebbar sein, wobei die Abstandsveränderungselemente in einem abgesenkten Zustand zwischen den geförderten Antennendrahtabschnitten angeordnet sind und in einem angehobenen Zustand nicht zwischen den geförderten Antennendrahtabschnitten angeordnet sind.

Mit anderen Worten kann die Bestückungsvorrichtung Abstandsstifte, insbesondere Paare von Abstandsstiften aufweisen, die aus einer Ruheposition in einen Bereich zwischen die zueinander parallelen Antennendrahtabschnitte hinein abgesenkt werden können und anschließend, durch eine Bewegung parallel zur Förderrichtung der Antennendrahtabschnitte, in Anlage mit den Antennendrahtabschnitten gebracht werden können. Weiter können die Abstandsstifte durch eine weitere Bewegung parallel zur Förderrichtung die Position der Antennendrahtabschnitte, welche sich nun in Anlage mit den Abstandsstiften befinden, so verändern, dass sich ein Abstand der Antennendrahtabschnitte zueinander, zumindest in einem Bereich der Abstandsstifte, erhöht. Hierbei kann sich die Materialspannung der Antennendrahtabschnitte ebenfalls temporär erhöhen. Nachdem der Transponderchip durch die Bestückungsvorrichtung zwischen den Antennendrahtabschnitten positioniert/angeordnet ist, können sich die Abstandsstifte entgegen der Bewegung zur Vergrößerung des Abstands zurückbewegen, sodass sich der Abstand der Antennendrahtabschnitte wieder verringert. Sobald sich die Abstandsstifte wieder zwischen den Antennendrahtabschnitten befinden und/oder sich nicht weiter in Anlage mit den Antennendrahtabschnitten befinden, können die Abstandsstifte wieder in die Ruheposition hinein angehoben werden bzw. aus dem Bereich zwischen den Antennendrahtabschnitten entfernt werden, sodass ein Förderweg in der Förderrichtung für die Antennendrahtabschnitte und den zwischen ihnen angeordneten Transponderchip freigegeben bzw. nicht behindert ist.

In einer Variante kann die Bestückungsvorrichtung weiter, alternativ oder ergänzend zu den Abstandsstiften, in einem Querschnitt dreieckförmige, zumindest abschnittsweise elliptische oder zumindest abschnittsweise trapezförmige Abstandsveränderungselemente in einen Bereich zwischen den parallel angeordneten Antennendrahtabschnitten einbringen, wobei die in einem Querschnitt dreieckförmigen, zumindest abschnittsweise elliptischen oder zumindest abschnittsweisen trapezförmige Abstandsveränderungselemente bereits durch das Absenken in den Bereich zwischen die Antennendrahtabschnitte zunächst in Anlage mit diesen gelangen und durch ein weiteres Absenken einen Abstand der Antennendrahtabschnitte zueinander temporär lokal vergrößern. Ein Anheben der in einem Querschnitt dreieckförmigen, zumindest abschnittsweise elliptischen oder zumindest abschnittsweise trapezförmigen Abstandsveränderungselemente beendet die temporäre Vergrößerung des Abstands der Antennendrahtabschnitte.

Der Fachmann versteht hierbei, dass die Anzahl der Abstandsveränderungselemente im Grundsatz frei gewählt werden kann und dass bereits ein einziges Abstandsveränderungselement im Grundsatz ausreichend ist, um einen Abstand der Antennendrähte zueinander temporär zu verändern. Ferner versteht der Fachmann, dass ein Absenken und ein Anheben im Sinne der Erfindung zwei zueinander entgegengesetzte Bewegungsrichtungen bezeichnen, jedoch keine Position der Bestückungsvorrichtung oder Teile der Bestückungsvorrichtung in Relation zu den geförderten Antennendrähten festlegen. Insbesondere kann sich eine Ruhelage der Abstandsveränderungselemente sowohl oberhalb als auch unterhalb der geförderten Antennendrähte befinden, sodass ein Absenken stets eine Bewegung der Abstandsveränderungselemente in den Bereich zwischen den Antennendrahtabschnitten hinein bezeichnet und ein Anheben stets eine Bewegung aus dem Bereich zwischen den Antennendrahtabschnitten heraus bezeichnet.

In einer Weiterbildung kann die Bestückungsvorrichtung ferner Unterstützungselemente, insbesondere Unterstützungsstifte, aufweisen, die dazu angeordnet und ausgebildet sind, einen temporär lokal vergrößerten Abstand der Antennendrahtabschnitte räumlich zumindest teilweise zu begrenzen. Insbesondere können die Unterstützungselemente jeweils an einer dem Bereich zwischen den Antennendrahtabschnitten abgewandten (Außen-)Seite der Antennendrahtabschnitte angeordnet sein. In einer Weiterbildung können die Unterstützungselemente zudem in einer Richtung in einem Winkel zur Förderrichtung und in einer hierzu korrespondierenden Gegenrichtung beweglich sein. Zudem können auch die Unterstützungselemente absenkbar und/oder anhebbar sein, zum Beispiel um einen Förderweg freizugeben.

Ein Vorteil hierbei ist, dass einem unbeabsichtigten Lösen der Antennendrähte von den Aufnehmern der Drahtfördereinheiten aufgrund einer Veränderung des Abstandes der zueinander geförderten Antennendrahtabschnitte bzw. Aufgrund einer Veränderung der Positionierung der Antennendrahtabschnitte entgegengewirkt wird.

Weiter kann die Vorrichtung zur Herstellung von RFID-Transpondern einen Flussmittelspender aufweisen der dazu angeordnet und ausgebildet ist, jeweils einen Flussmittelauftrag, der ein Verlöten der Antennendrähte mit einem Transponderchip erleichtert, auf die Antennendrähte aufzutragen.

Ferner kann eine Lötvorrichtung dazu angeordnet und ausgebildet sein, jeweils ein Lot auf die zueinander parallelen Antennendrahtabschnitte und/oder auf einen Transponderchip bzw. auf einen Teil eines Transponderchips aufzubringen und die zueinander parallelen Antennendrahtabschnitte mit einem zwischen ihnen angeordneten Transponderchip zu verlöten; insbesondere kann die Lötvorrichtung gemeinsam bzw. als gemeinsame baugruppe mit der Bestückungsvorrichtung ausgebildet sein.

Eine Verbindungsvorrichtung kann dazu angeordnet und ausgebildet sein, eine elektrisch leitende Verbindung zwischen den Antennendrähten herzustellen. Hierzu kann zum Beispiel eine elektrisch leitende Verbindung durch einen elektrisch leitenden Materialauftrag, welcher zum Beispiel eine Silberverbindung oder eine silberhaltige Verbindungssubstanz sein kann, zwischen den zueinander parallelen Antennendrahtabschnitten hergestellt werden. Alternativ können die Antennendrähte zum Beispiel auch miteinander verlötet werden oder es kann ein elektrisch leitendes Verbindungselement zwischen den parallelen Antennendrahtabschnitten angeordnet und mit diesen elektrisch leitend verbunden, insbesondere verlötet werden.

Weiter kann eine Isolationsvorrichtung dazu angeordnet und ausgebildet sein, zumindest einen Teil der Antennendrähte und/oder zumindest einen Teil der elektrisch leitenden Verbindung mit einem Isolationsmaterial zu umgeben. Dieses kann zum Beispiel durch einen dielektrischen Materialauftrag, insbesondere durch eine Isolationslackierung, geschehen. In einer Weiterbildung kann die Isolationsvorrichtung zudem eine UV-Bestrahlungsvorrichtung umfassen, die dazu angeordnet ist, einen durch die Isolationsvorrichtung aufgebrachten Materialauftrag, insbesondere eine Isolationslackierung, mittels UV-Licht anzutrocknen und/oder auszuhärten.

Eine Trennvorrichtung, insbesondere eine Laser-Trennvorrichtung kann dazu angeordnet und ausgebildet sein, zumindest einen der Antennendrähte und/oder zumindest einen Teil des Isolationsmaterials zu durchtrennen/perforieren/unterbrechen. Hierdurch kann eine Länge einer Antenne einer zu fertigenden Transponderanordnung eingestellt bzw. hergestellt werden. Insbesondere können offene bzw. nicht zu einer Schleife geformte Enden einer Antenne gleichlang oder unterschiedlich lang hergestellt werden.

Zusätzlich kann eine Versiegelungsvorrichtung dazu angeordnet und ausgebildet sein, eine Versiegelung zumindest auf einen Teil des Transponderchips und/oder auf das Isolationsmaterial und/oder auf die Antennendrähte aufzutragen. Die Versiegelung kann insbesondere ein mittels UV-Licht aushärtbarer Materialauftrag sein. Hierzu kann auch die Versiegelungsvorrichtung eine UV-Bestrahlungsvorrichtung umfassen, die dazu angeordnet ist, einen durch die Versiegelungsvorrichtung aufgebrachten Materialauftrag mittels UV-Licht anzutrocknen und/oder auszuhärten.

Weiter kann die Vorrichtung zur Herstellung von RFID-Transpondern eine Inspektionsvorrichtung umfassen, die dazu angeordnet und ausgebildet ist, Eigenschafts- und/oder Positionierungsfehler eines Transponderchips und/oder einer Transponderanordnung zu ermitteln. Eine Transponderanordnung bezeichnet hierbei eine Anordnung umfassend einen Transponderchip und zumindest jeweils einen Abschnitt von zumindest zwei Antennendrähten und/oder eine elektrisch leitende Verbindung und/oder ein Isolationsmaterial und/oder eine Versiegelung. Die Inspektionsvorrichtung kann zum Beispiel optisch erfassende Sensoren, insbesondere eine Kameraanordnung, aufweisen, die dazu geeignet ist Lage- bzw. Positionierungsfehler einer Transponderanordnung und/oder eines Teils der Transponderanordnung zu ermitteln und/oder optisch erkennbare Eigenschaftsfehler der Transponderanordnung und/oder eines Teils der Transponderanordnung zu ermitteln. In einer Weiterbildung kann die Inspektionsvorrichtung auch eine Vorrichtung Auslesen von RFID-Transpondern umfassen, die dazu angeordnet und ausgebildet ist, eine Transponderanordnung/einen RFID-Transponder auf Funktionsfähigkeit zu überprüfen. Ferner kann die Inspektionsvorrichtung eine Schreibvorrichtung aufweisen, die dazu angeordnet und ausgebildet ist, eine Transponderanordnung/einen RFID-Transponder zu Codieren bzw. Daten an eine Transponderanordnung/einen RFID-Transponder zu übertragen. Optional kann die Schreibvorrichtung gemeinsam mit der Vorrichtung zum Codieren und/oder Auslesen von RFID-Transpondern ausgebildet sein.

In einer Variante kann die Transponderanordnung weiter eine Vereinzelungsvorrichtung aufweisen, die dazu angeordnet und ausgebildet ist, die Antennendrähte und/oder das Isolationsmaterial jeweils zu durchtrennen, sodass jeweils eine vereinzelte Transponderanordnung mit zumindest einem Transponderchip und zumindest einer Antennenanordnung, insbesondere einer Schleifenantenne, entsteht/hergestellt wird, wobei die Antennenanordnung der Transponderanordnung zumindest einen Abschnitt der durchtrennten Antennendrähte und/oder der elektrisch leitenden Verbindung umfasst.

Ein Verfahren zur Herstellung von RFID-Transpondern weist die folgenden Schritte auf:
- Bereitstellen von zumindest zwei Antennendrähten, die von einer Drahtfördervorrichtung mit zumindest zwei Drahtfördereinheiten in einer Förderrichtung gefördert werden, wobei die Drahtfördereinheiten dazu angeordnet und ausgebildet sind, im Zusammenwirken die Antennendrähte zueinander zumindest abschnittsweise parallel und in einem Winkel zur Förderrichtung zu spannen/aufzuspannen, sodass die abschnittsweise zueinander parallelen Antennendrähte eine Materialspannung in einem Winkel zur Förderrichtung aufweisen; und
- Anordnen eines Transponderchips zwischen den zueinander zumindest abschnittsweise parallelen und in einem Winkel zur Förderrichtung gespannten Antennendrähten.

Optional kann das Verfahren zudem einen oder mehrere der folgenden Schritte aufweisen:
- Auftragen eines Flussmittelauftrags auf die Antennendrähte; und/oder
- Aufbringen eines Lots auf die Antennendrähte und/oder auf einen Transponderchip und Verlöten der zumindest abschnittsweise zueinander parallelen Antennendrähte mit einem zwischen den Antennendrähten angeordneten Transponderchip; und/oder
- Herstellen zumindest einer elektrisch leitenden Verbindung zwischen den zumindest zwei Antennendrähten; und/oder
- Umgeben zumindest eines Teils der Antennendrähte und/oder zumindest eines Teils der elektrisch leitenden Verbindung mit einem Isolationsmaterial; und/oder
- Durchtrennen zumindest eines Teils der Antennendrähte und/oder zumindest eines Teils des Isolationsmaterials; und/oder
- Auftragen einer Versiegelung zumindest auf einen Teil des Transponderchips und/oder auf das Isolationsmaterial und/oder auf die Antennendrähte; und/oder
- Ermitteln von Eigenschafts- und/oder Positionierungsfehlern eines Transponderchips und/oder einer Transponderanordnung.

Es ist für den Fachmann ersichtlich, dass die zuvor beschriebenen Aspekte und Merkmale beliebig kombiniert werden können.

### Kurzbeschreibung der Figuren

Weitere Merkmale, Eigenschaften, Vorteile und mögliche Abwandlungen werden für einen Fachmann anhand der nachstehenden Beschreibung deutlich, in der auf die beigefügten Zeichnungen Bezug genommen ist. Dabei zeigen alle beschriebenen und/oder bildlich dargestellten Merkmale für sich oder in beliebiger Kombination den hier offenbarten Gegenstand. Die Abmessungen und Proportionen der in den Figuren gezeigten Vorrichtungen und Komponenten sind nicht maßstäblich.
- Fig. 1a - 1c: zeigen schematisch Beispiele für Transponderchips, die für eine Handhabung mit den offenbarten Vorrichtungen geeignet sind und eine schematische Darstellung einer Transponderanordnung, die mit den offenbarten Vorrichtungen hergestellt werden kann.
- Fig. 2: zeigt schematisch ein Beispiel für eine Vorrichtung zur Herstellung von RFID-Transpondern mit einer Gleitfläche.
- Fig. 3: zeigt schematisch ein Beispiel für eine Positionierung eines Transponderchips zwischen zwei zueinander parallel geförderten Antennendrähten mit einer Bestückungseinrichtung.
- Fig. 4: zeigt schematisch ein Beispiel für einzelne Schritte einer Herstellung einer Transponderanordnung mit einer Vorrichtung wie in Fig. 2 gezeigt.
- Fig. 5: zeigt schematisch ein Beispiel für eine Vorrichtung zur Herstellung von RFID-Transpondern mit winklig zur Förderrichtung gespannten Antennendrähten.
- Fig. 6: zeigt schematisch ein Beispiel für eine Positionierung eines Transponderchips zwischen zwei zueinander parallel geförderten Antennendrähten mit einer Bestückungseinrichtung.
- Fig. 7: zeigt schematisch ein Beispiel für einzelne Schritte einer Herstellung einer Transponderanordnung mit einer Vorrichtung wie in Fig. 5 gezeigt.
- Fig. 8: zeigt schematisch ein Beispiel für einzelne Schritte einer Herstellung einer Transponderanordnung.

### Detaillierte Beschreibung der Figuren

Vergleichbare bzw. gleiche und gleichwirkende Komponenten und Merkmale sind in den Figuren jeweils mit denselben Bezugszeichen versehen. Teilweise ist in den Figuren aus Übersichtsgründen auch auf Bezugszeichen einzelner Merkmale und Komponenten verzichtet worden, wobei diese Merkmale und Komponenten in anderen Figuren bereits mit Bezugszeichen versehen sind. Die Komponenten und Merkmale, die in Bezug auf die weiteren Figuren nicht erneut beschrieben sind, ähneln in ihrer Ausbildung und Funktion den entsprechenden Komponenten und Merkmalen gemäß den anderen Figuren.

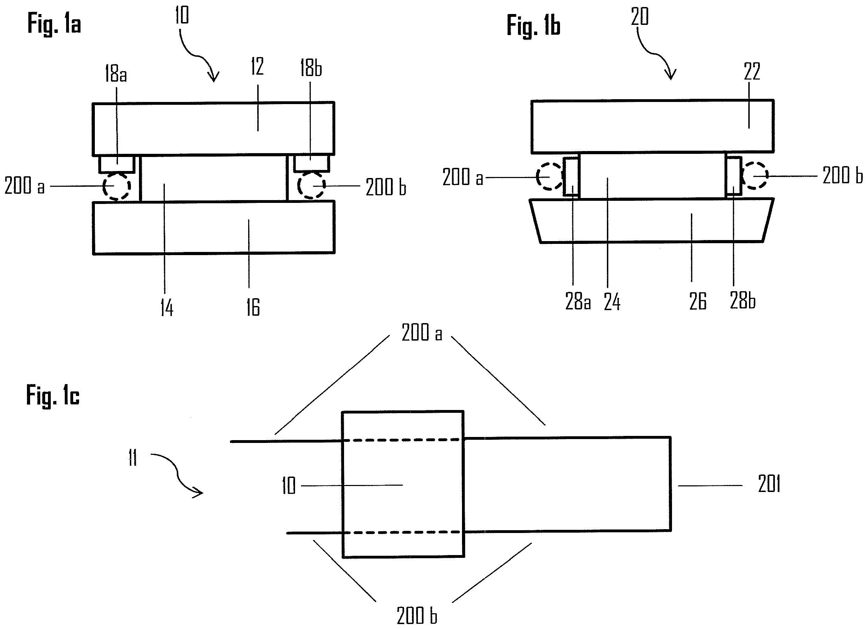

Fig. 1a und 1b zeigen jeweils Beispiele für Transponderchips 10; 20, welche sich für eine Handhabung mit den offenbarten Vorrichtungen eignen, in einer Querschnittsansicht. Die gezeigten Transponderchips 10; 20 sind jedoch nur Beispiele zum verbesserten Verständnis der offenbarten Vorrichtungen, welche sich selbstverständlich ebenso auch für die Handhabung anderer, hier nicht gezeigter elektronischer Bauteile eignen.

Fig. 1a zeigt ein Beispiel für einen Transponderchip 10 mit im Wesentlichen quaderförmigen Außenelementen 12, 16, welche ein ebenfalls im Wesentlichen quaderförmiges Innenelement 14 teilweise umgeben. Die Außenelemente 12, 16 bilden gemeinsam mit dem Innenelement 14 jeweils eine seitliche Vertiefung an zwei einander gegenüberliegenden Seitenflächen des Transponderchips 10 aus, welche jeweils zur Aufnahme bzw. zur Anordnung von Antennendrähten 200a, 200b geeignet sind. Hierzu weist der schematisch gezeigte Transponderchip 10 im Bereich der seitlichen Vertiefungen jeweils elektrische Kontakte 18a, 18b für eine Transponderantenne auf. Die Kontakte 18a, 18b sind hierbei jeweils so angeordnet, dass sie jeweils in den seitlichen Vertiefungen anzuordnende Antennendrähte 200a, 200b elektrisch leitend kontaktieren.

Fig. 1b zeigt schematisch einen alternativen Transponderchip 20. Der Transponderchip 20 hat ebenfalls ein im Wesentlichen quaderförmiges Außenelement 22 und ein im Wesentlichen quaderförmiges Innenelement 24. Abweichend von dem in Fig. 1a schematisch gezeigten Beispiel hat der Transponderchip 20 jedoch ein pyramidenstumpfförmiges Außenelement 26, welches abgeschrägte Außenflächen aufweist, die eine Positionierung des Transponderchips 20 zwischen zwei parallele Antennendrähte 200a, 200b erleichtern.

Analog zu dem in Fig. 1a gezeigten Beispiel weist auch der Transponderchip 20 seitliche Vertiefungen an zwei einander gegenüberliegenden Seitenflächen auf, die jeweils dazu geeignet sind, die Antennendrähte 200a, 200b aufzunehmen. Ferner hat der Transponderchip 20 die elektrischen Kontakte 28a, 28b, die jeweils so angeordnet sind, dass sie jeweils in den seitlichen Vertiefungen anzuordnende Antennendrähte 200a, 200b elektrisch leitend kontaktieren.

Die gezeigten seitlichen Vertiefungen sind jedoch ausdrücklich nicht notwendig, damit sich ein Transponderchip für eine Handhabung durch die im Folgenden beschriebenen Vorrichtungen eignet. Ebenso können - zum Beispiel - auch T-förmige elektronische Bauteile, insbesondere T-förmige Transponderchips, zwischen den Antennendrähten positioniert werden.

Fig. 1c zeigt schematisch vereinfacht eine Transponderanordnung 11, wie sie von den im Folgenden beschriebenen Vorrichtungen hergestellt werden kann. Die Transponderanordnung 11 umfasst einen Transponderchip 10, der zwischen zwei Antennendrähten 200a, 200b angeordnet ist, wobei die Antennendrähte 200a, 200b jeweils die elektrischen Kontakte 18a, 18b (in Fig. 1c nicht gezeigt, siehe Fig. 1a) des Transponderchips 10 kontaktieren. Die Antennendrähte 200a, 200b sind mit einer elektrisch leitenden Verbindung 201 zu einer Schleifenantenne verbunden. Ferner sind die Enden der Antennendrähte 200a, 200b, welche auf der der Schleifenantenne abgewandten Seite des Transponderchips 10 angeordnet sind, ungleich bzw. ungleich lang ausgebildet.

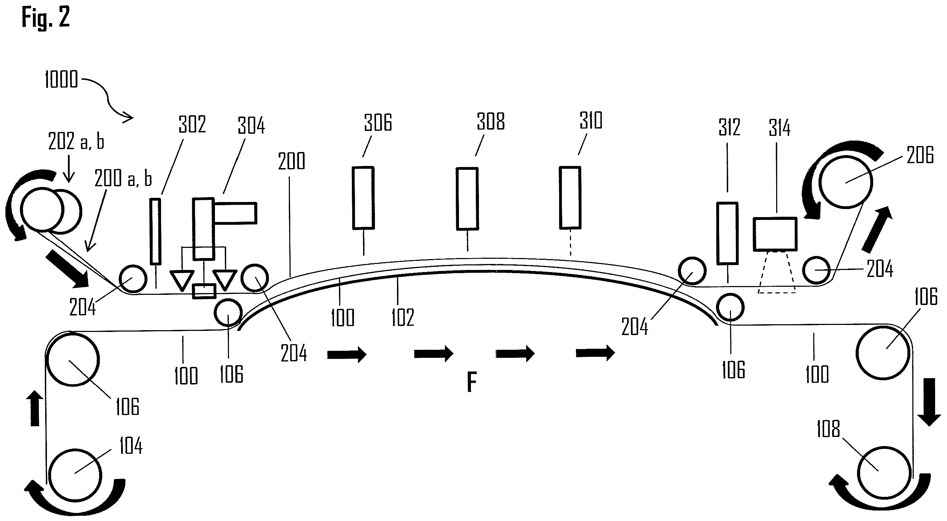

Fig. 2 zeigt eine Vorrichtung 1000 zur Herstellung von RFID-Transpondern.

Hierbei wird ein erster Antennendraht 200a von einer ersten Bereitstellungsrolle 202a als quasi-endloser Antennendraht bereitgestellt und taktweise über die Umlenkrollen 204 zu einer Aufnahmerolle 206 gefördert. Parallel zu dem ersten Antennendraht 200a wird ein zweiter Antennendraht 200b von einer zweiten Bereitstellungsrolle 202b als quasi-endloser Antennendraht bereitgestellt und taktweise über die Umlenkrollen 204 zu einer Aufnahmerolle 206 gefördert. Die taktweise geförderten Antennendrähte 200a, 200b sind hierbei zueinander parallel angeordnet und werden von den Umlenk- und Aufnahmerollen zueinander parallel gefördert. Mit anderen Worten sind die Antennendrähte 200a, 200b zueinander geometrisch parallel angeordnet und werden jeweils gleichzeitig taktweise von den Bereitstellungsrollen 202a, 202b zu der Aufnahmerolle 206 gefördert.

Ferner zeigt die Fig. 2 schematisch eine konvexe Gleitfläche 102. Die Gleitfläche 102 ist im gezeigten Beispiel mit Polytetrafluorethylen beschichtet. Die Gleitfläche 102 ist die den Antennendrähten 200a, 200b zugewandte Oberfläche eines in der Fig. 2 lediglich schematisch angedeuteten Körpers unterhalb des Förderwegs der Antennendrähte 200a, 200b.

Die zueinander parallel angeordneten Antennendrähte 200a, 200b werden von den Bereitstellungs-, Umlenk- und Aufnahmerollen jeweils zueinander zeitlich und geometrisch parallel über die Gleitfläche 102 hinweg in der Förderrichtung F gefördert.

Weiter umfasst die in Fig. 2 gezeigte Vorrichtung eine Unterlagenbereitstellungsrolle 104, die Unterlagenumlenkrollen 106 und eine Unterlagenaufnahmerolle 108. Die Unterlagenbereitstellungsrolle 104, die Unterlagenumlenkrollen 106 und die Unterlagenaufnahmerolle 108 fördern gemeinsam ein streifenförmiges quasi-endloses Silikonpapier 100 in der Förderrichtung F über die Gleitfläche 102.

Die Förderung des Silikonpapiers geschieht analog zur Förderung der Antennendrähte 200a, 200b taktweise. Weiter wird das streifenförmige quasi-endlose Silikonpapier in der gleichen Geschwindigkeit in der Förderrichtung F über die Gleitfläche 102 gefördert wie die Antennendrähte 200a, 200b, sodass im Bereich der Gleitfläche 102 keine oder nahezu keine Relativbewegung und/oder Relativgeschwindigkeit zwischen den Antennendrähten 200a, 200b und dem streifenförmigen Silikonpapier 100 auftritt.

Das Silikonpapier 100 wird von der Unterlagenbereitstellungsrolle 104, den Unterlagenumlenkrollen 106 und der Unterlagenaufnahmerolle 108 mit einer Materialspannung und in Anlage mit der Gleitfläche 102 gefördert. Die konvexe Gleitfläche 102 verlängert einen Förderweg des Silikonpapiers 100 zwischen den Umlenkrollen 106 und bewirkt somit im Zusammenwirken mit der Unterlagenbereitstellungsrolle 104, den Unterlagenumlenkrollen 106 und der Unterlagenaufnahmerolle 108 die Materialspannung des Silikonpapiers 100. Im Bereich der Gleitfläche 102 ist die Materialspannung des Silikonpapiers im Wesentlichen in Richtung der Förderrichtung F gerichtet.

Die Materialspannung des Silikonpapiers 100 stellt einerseits sicher, dass das Silikonpapier 100 stets in Anlage mit der Gleitfläche 102 gefördert wird und bewirkt zum anderen, das ein unbeabsichtigtes Verrutschen oder Falten des Silikonpapiers 100 während der Verarbeitung unterbunden oder zumindest erschwert wird.

Weiter sind in dem in Fig. 2 gezeigten Beispiel die Bereitstellungsrollen 202a, 202b, die Umlenkrollen 204 und die gemeinsame Aufnahmerolle 206 dazu angeordnet und ausgebildet, die taktweise parallel geförderten Antennendrähte 200a, 200b in Anlage mit dem Silikonpapier 100 und mit einer Materialspannung zu fördern. Die Materialspannung der Antennendrähte 200a, 200b wird hierbei durch ein Zusammenwirken der Bereitstellungsrollen 202a, 202b, der Umlenkrollen 204, der gemeinsamen Aufnahmerolle 206 und der konvexen/gekrümmten Gleitfläche 102 mit dem auf der Gleitfläche 102 geförderten Silikonpapier 100 hervorgerufen/bewirkt.

Beispielsweise können entlang des Förderwegs der Antennendrähte 200a, 200b zwischen den Bereitstellungsrollen 202a, 202b und der Aufnahmerolle 206 vier Umlenkrollen(-paare) 204 angeordnet sein, wobei zwei Umlenkrollen(-paare) 204 der Gleitfläche 102 zugeordnet sein können.

Die konvexe Gleitfläche 102 mit dem auf ihr geförderten Silikonpapier verlängert einen Förderweg der Antennendrähte 200a, 200b zwischen den Umlenkrollen 106 und bewirkt somit im Zusammenwirken mit den Bereitstellungsrollen 202a, 202b, den Umlenkrollen 204 und der gemeinsamen Aufnahmerolle 206 die Materialspannung der Antennendrähte 200a, 200b. Im Bereich der Gleitfläche 102 ist die Materialspannung der Antennendrähte 200a, 200b im Wesentlichen in Richtung der Förderrichtung F gerichtet.

Die Materialspannung der Antennendrähte 200a, 200b ermöglicht deren präzises und geradliniges Ausrichten für eine Verarbeitung und wirkt einem unbeabsichtigten Verrutschen der Antennendrähte 200a, 200b während der Verarbeitung entgegen.

Ein Vorteil der konvexen Gleitfläche ist es, dass eine Materialspannung der Antennendrähte 200a, 200b über eine längere Distanz und/oder mit einer geringeren ausgeübten Spannkraft erreicht werden kann, als dieses mit frei gespannten Drähten möglich wäre. Zudem wird ein Einfluss der Schwerkraft auf die gespannten Drähte vermindert und eine qualitative Verteilung der Materialspannung in den Antennendrähten wird verbessert. Ferner wird ein unerwünschtes Verdrehen oder Verdrillen der Antennendrähte verhindert oder zumindest erschwert.

Die gezeigte Vorrichtung 1000 umfasst weiter einen Flussmittelspender 302, wenigstens eine Bestückungsvorrichtung 304 mit integrierter Lötvorrichtung zur Anordnung von Transponderchips, eine Verbindungsvorrichtung 306 zur elektrischen Kontaktierung der parallel geförderten Antennendrähte 200a und 200b und eine Isolationsvorrichtung 308 zum Auftragen einer Isolationslackierung auf die Antennendrähte 200a und 200b. Zudem umfasst die Vorrichtung 1000 weiter eine Laser-Trennvorrichtung 310, welche dazu angeordnet und ausgebildet ist, einen der Antennendrähte 200a, 200b mit einem Laser zu durchtrennen, und eine Versiegelungsvorrichtung 312, welche eine Schutzversiegelung auf den Transponderchip, der zwischen den Antennendrähten angeordnet wurde, aufzutragen.

Eine Inspektionsvorrichtung 314 überprüft mit optischen und elektronischen Sensoren bzw. Auslesevorrichtungen, ob die gefertigten Transponderanordnungen vorbestimmten Qualitätsanforderungen entsprechen.

Die Bearbeitungsvorrichtungen 306 bis 310 sind oberhalb der über die Gleitfläche 102 geförderten Antennendrähte 200a, 200b und dem geförderten Silikonpapier 100 bzw. oberhalb der Gleitfläche 102 angeordnet. Das parallel mit den Antennendrähten 200a, 200b geförderte Silikonpapier 100 kann somit ein verschmutzen der Gleitfläche 102, zum Beispiel durch den von der Isolationsvorrichtung 308 abgegeben Isolationslack verhindern.

Der Flussmittelspender 302, die Bestückungsvorrichtung 304 und die Inspektionsvorrichtung 314 sind nicht oberhalb der Gleitfläche 102 angeordnet.

In anderen Ausführungsformen (nicht gezeigt) können zusätzliche Bearbeitungsstationen oberhalb bzw. im Bereich der taktweise parallel geförderten Antennendrähte angeordnet sein. Zumindest ein Teil der Bearbeitungsstationen kann oberhalb der Gleitfläche angeordnet sein und zumindest ein Teil der Bearbeitungsstationen kann oberhalb der geförderten Antennendrähte, jedoch abseits der Gleitfläche, angeordnet sein.

Im gezeigten Beispiel werden die durch die Bearbeitungsstationen 302 bis 314 hergestellten Transponderanordnungen als quasi-endlose Folge von Transponderanordnungen auf die Aufnahmerolle 206 aufgerollt. In einer alternativen Ausführungsform (nicht gezeigt) können die hergestellten Transponderanordnungen zudem in einem weiteren Bearbeitungsschritt durch ein Durchtrennen der Antennendrähte 200a, 200b vereinzelt werden, sodass einzelne Transponderanordnungen, wie zum Beispiel in Fig. 1c gezeigt, entstehen.

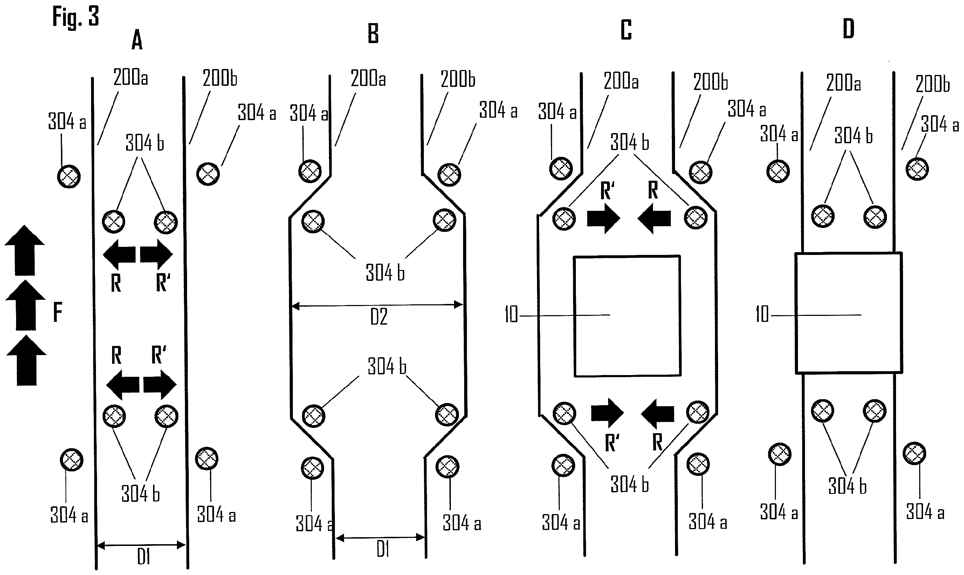

Fig. 3 zeigt schematisch die Anordnung eines Transponderchips 10 zwischen den Antennendrähten 200a, 200b durch die Bestückungsvorrichtung 304. Fig. 3 zeigt die zueinander parallel geförderten Antennendrähte in einer Draufsicht bzw. in einer im Vergleich zu Fig. 2 um 90° gedrehten Perspektive.

In einem ersten Schritt (A) werden vier Abstandsstifte 304b aus einer Ruhelage oberhalb der taktweise parallel geförderten Antennendrähte 200a, 200b in den Bereich zwischen die Antennendrähte 200a, 200b hinein abgesenkt. Die Abstandsstifte 304b sind im gezeigten Beispiel jeweils paarweise angeordnet bzw. symmetrisch zu den Antennendrähten 200a, 200b angeordnet. Mit anderen Worten kann beschrieben werden, dass die vier Abstandsstifte 304b im Bereich zwischen den Antennendrähten 200a, 200b gemeinsam die Eckpunkte eines Rechtecks definieren, wobei die Antennendrähte 200a, 200b jeweils parallel zu zwei Seiten des Rechtecks verlaufen.

Weiter werden im in Fig. 3 gezeigten Beispiel vier Unterstützungsstifte 304a aus einer Ruhelage oberhalb der taktweise parallel geförderten Antennendrähte 200a, 200b in den Bereich außerhalb des von den Antennendrähten 200a, 200b umformten Innenraums abgesenkt. Die Unterstützungsstifte 304a sind im gezeigten Beispiel ebenfalls jeweils paarweise angeordnet bzw. symmetrisch zu den Antennendrähten 200a, 200b angeordnet. Mit anderen Worten kann beschrieben werden, dass die vier Unterstützungsstifte 304a gemeinsam die Eckpunkte eines Rechtecks definieren, wobei die Antennendrähte 200a, 200b jeweils parallel zu zwei Seiten des Rechtecks verlaufen.

Nachdem die Unterstützungsstifte 304a und die Abstandsstifte 304b abgesenkt sind, werden die Abstandsstifte 304b jeweils in einer Richtung R sowie in einer Gegenrichtung R' bewegt. Die Richtung R und die Gegenrichtung R' verlaufen hierbei, in einer Draufsicht auf die parallelen Antennendrähte 200a, 200b, jeweils orthogonal zur Förderrichtung F der in Fig. 2 gezeigten Vorrichtung.

Die parallelen Antennendrähte 200a, 200b werden von der in Fig. 2 gezeigten Vorrichtung in einem Abstand D1 zueinander parallel gefördert. Fig. 3 zeigt, dass die Bestückungsvorrichtung 304 in einem zweiten Schritt (B) den Abstand der Antennendrähte 200a, 200b temporär und lokal bis zu einem Bestückungsabstand D2 erhöht, indem die Abstandsstifte 304b jeweils in einer Richtung R sowie in einer Gegenrichtung R' bewegt werden. Die Unterstützungsstifte 304a bewirken hierbei, dass die Vergrößerung des Abstands der Antennendrähte 200a, 200b zueinander im Wesentlichen lokal begrenzt ist, sodass die Bearbeitungsvorgänge an anderen Bearbeitungsstationen nicht beeinträchtigt werden.

Weiter zeigt Fig. 3, dass die Bestückungsvorrichtung 304 in einem dritten Schritt (C) einen Transponderchip 10 zwischen den Antennendrähten im Bereich des temporär erhöhten Bestückungsabstands D2 anordnet. Das Anordnen des Transponderchips 10, welcher an zwei einander gegenüberliegenden und den Antennendrähten 200a, 200b jeweils zugewandten Seitenflächen Vertiefungen zur Aufnahme der Antennendrähte 200a, 200b aufweist, kann zum Beispiel mit einem Vakuumgreifer (nicht gezeigt) oder einer anderen Vorrichtung zur Handhabung von Transponderchips geschehen. Nachdem der Transponderchip 10 zwischen den Antennendrähten 200a, 200b positioniert ist, werden die Abstandsstifte 304b jeweils entgegen der Richtung, in der sie zur temporären Veränderung des Abstandes der Antennendrähte bewegt wurden, zurückbewegt, bis in einem vierten Schritt (D) die Antennendrähte 200a, 200b in Anlage mit den Vertiefungen des Transponderchips angeordnet sind. Die Bestückungsvorrichtung hebt nun die Unterstützungsstifte 304a und die Abstandsstifte 304b an, bis diese wieder in der Ruhelage oberhalb der taktweise parallel geförderten Antennendrähte 200a, 200b positioniert sind, sodass ein Förderweg entlang der Förderrichtung F für die parallelen Antennendrähte 200a, 200b und den zwischen ihnen angeordneten Transponderchip 10 freigegeben ist. Anschließend werden die parallelen Antennendrähte 200a, 200b und der zwischen ihnen angeordnete Transponderchip 10 entlang der Förderrichtung F gefördert.

Der Vakuumgreifer kann zum Beispiel Teil einer "Pick- & Place" Einrichtung sein, die den Chip an einem Abholort, zum Beispiel von einem bereitgestellten Wafer, aufnimmt und zwischen den Antennendrähten platziert.

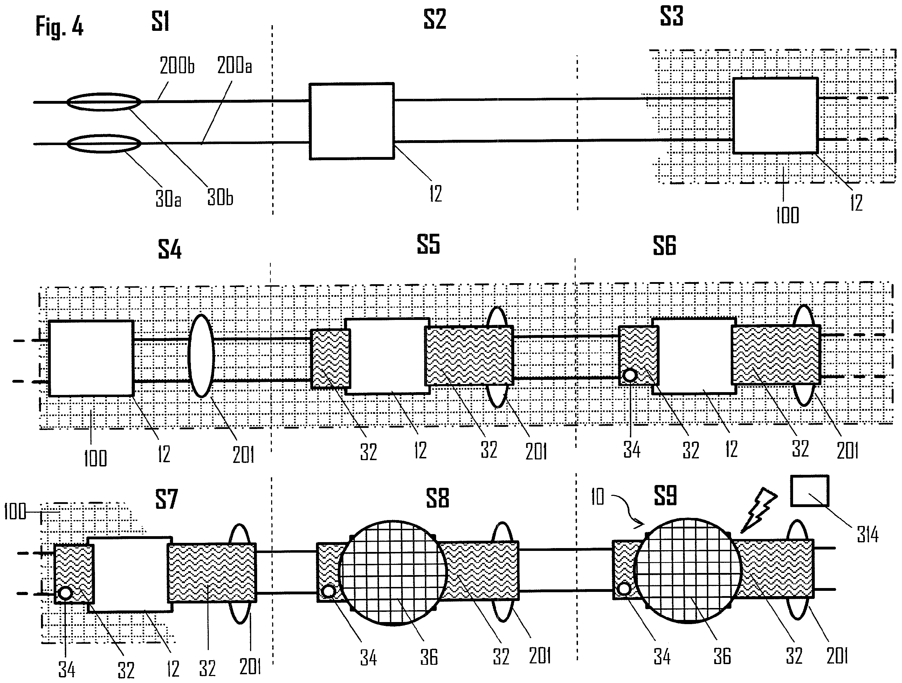

Fig. 4 zeigt schematisch eine schrittweise Fertigung einer Transponderanordnung mit einer Vorrichtung nach Fig. 2. Gleichzeitig verdeutlicht Fig. 4, dass sich bei einer Vorrichtung nach Fig. 2 jeweils Transponderanordnungen unterschiedlicher Fertigungsstadien an den quasiendlos bereitgestellten parallelen Antennendrähten 200a, 200b befinden können. Die in unterschiedlichen Fertigungsstadien befindlichen Transponderanordnungen werden jeweils taktweise von einer Fertigungsstation zu einer weiteren Fertigungsstation gefördert, wobei jede Fertigungsstation zumindest einen Bearbeitungsvorgang ausführt.

In einem ersten Schritt S1 wird jeweils ein Flussmittel 30a, 30b durch den Flussmittelspender 302 auf die taktweise parallel geförderten Antennendrähte 200a, 200b aufgetragen.

In einem zweiten Schritt S2 wird, wie zu Fig. 3 ausführlich beschrieben, ein Transponderchip 10 zwischen den zueinander parallelen Antennendrähten 200a, 200b angeordnet. Ferner wird der Transponderchip 10 mit den Antennendrähten 200a, 200b verlötet, sodass eine elektrisch leitende Verbindung zwischen den Antennendrähten 200a, 200b und den Kontakten 18a, 18b des Transponderchips 10 (nicht in Fig. 4 gezeigt, siehe Fig. 1) hergestellt ist.

In einem dritten Schritte S3 werden die parallelen Antennendrähte 200a, 200b weiter taktweise entlang der Förderrichtung F gefördert, bis die Antennendrähte 200a, 200b und der mit ihnen verlötete Transponderchip 10 in Anlage mit dem Silikonpapier 100 angeordnet sind, welches taktweise und mit der gleichen Fördergeschwindigkeit wie die Antennendrähte 200a, 200b über die Gleitfläche 102 gefördert wird.

In einem vierten Schritt S4 wird durch die Verbindungsvorrichtung 306 eine elektrisch leitende Verbindung 201 zwischen den parallel geförderten Antennendrähten 200a, 200b hergestellt.

In einem fünften Schritt S5 wird durch die Isolationsvorrichtung 308 eine elektrische Isolierung 32 bzw. ein Dielektrikum auf einen Teil der geförderten Antennendrähte 200a, 200b und auf einen Teil des Transponderchips 10 aufgebracht. Das Silikonpapier 100 verhindert hierbei, dass die aufgebrachte Isolierung 32 die Gleitunterlage 102 verunreinigt. Die Isolierung 32 wird mittels UV-Licht angetrocknet bzw. ausgehärtet.

In einem optionalen sechsten Schritt S6 wird einer der geförderten Antennendrähte 200a und ein Teil der aufgebrachten Isolierung 34 von einer Laser-Trennvorrichtung 310 durchtrennt. Hierdurch entsteht eine Ausnehmung/Auslassung 34 in der Isolierung und in einem der Antennendrähte 200a. Hierdurch kann eine Transponderanordnung mit ungleichartig ausgestalteten Antennenenden hergestellt werden.

In einem siebten Schritt S7 werden die parallelen Antennendrähte 200a, 200b weiter taktweise entlang der Förderrichtung F gefördert, bis die Antennendrähte 200a, 200b und der mit ihnen verlötete Transponderchip 10 nicht mehr in Anlage mit dem Silikonpapier 100 angeordnet sind.

In einem achten Schritt S8 wird durch die Versiegelungsvorrichtung 312 eine Versiegelung 36 auf den Transponderchip 10 und auf einen Teil der Isolierung 34 aufgetragen. Die Versiegelung 36 wird ebenfalls mittels UV-Licht angetrocknet bzw. ausgehärtet.

In einem neunten Schritt S9 wird die Funktionsfähigkeit der gefertigten Transponderanordnung mit einer Inspektionsvorrichtung 314 überprüft.

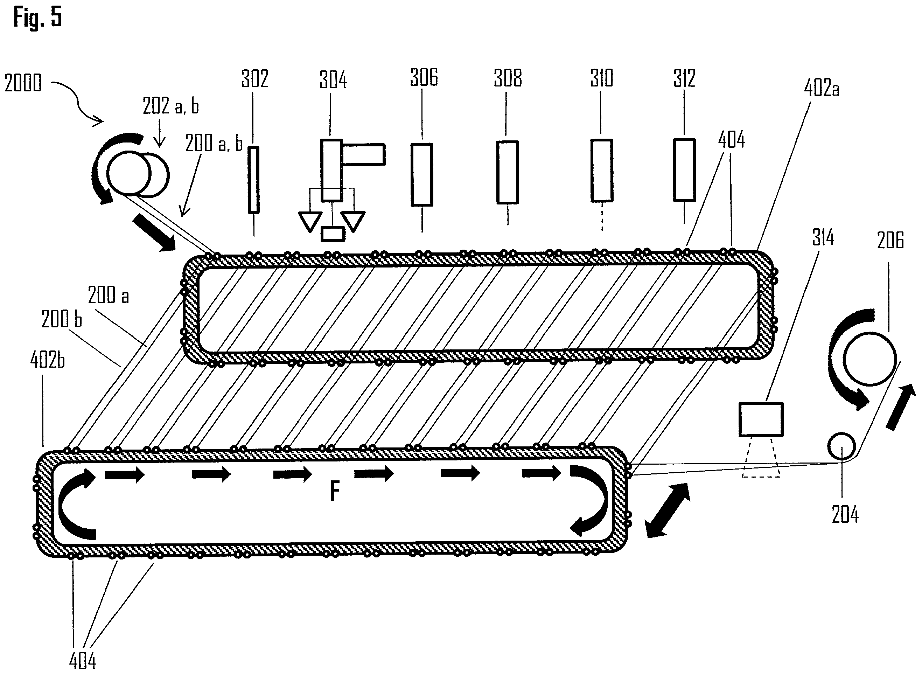

Fig. 5 zeigt eine Vorrichtung 2000 zur Herstellung von RFID-Transpondern.

Die Vorrichtung 200 weist zwei Bereitstellungsrollen 202a, 202b auf, die jeweils einen quasi-endlosen Antennendraht 200a, 200b bereitstellen. Die bereitgestellten quasi-endlosen Antennendrähte 200a, 200b werden jeweils von einer Verlegeeinrichtung (nicht gezeigt) mit je einem Verlegearm (nicht gezeigt) für jeden der zwei bereitgestellten Antennendrähte 200a, 200b zwischen den in Fig. 5 gezeigten Drahtfördereinheiten 402a, 402b aufgespannt.

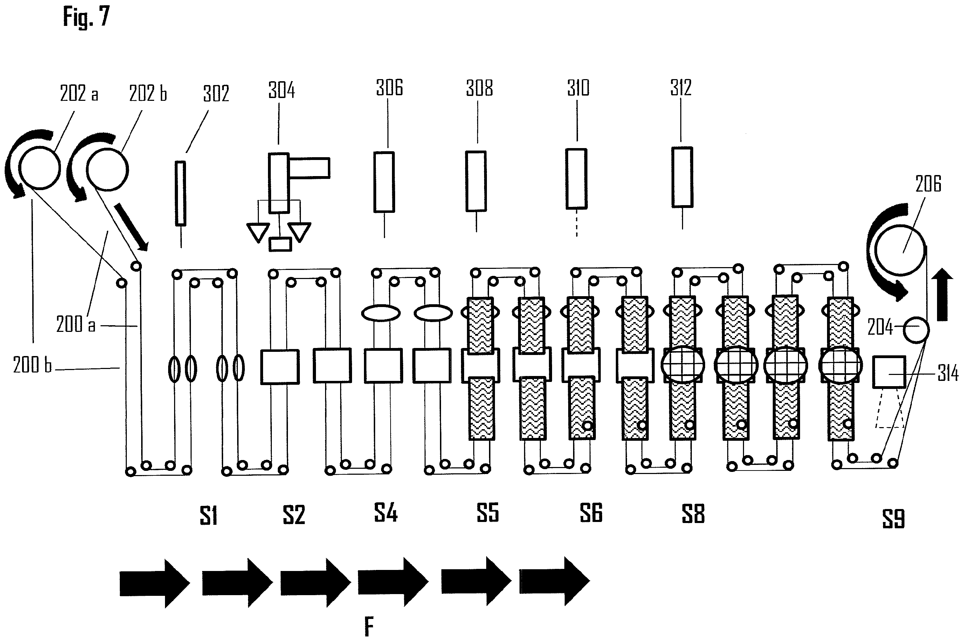

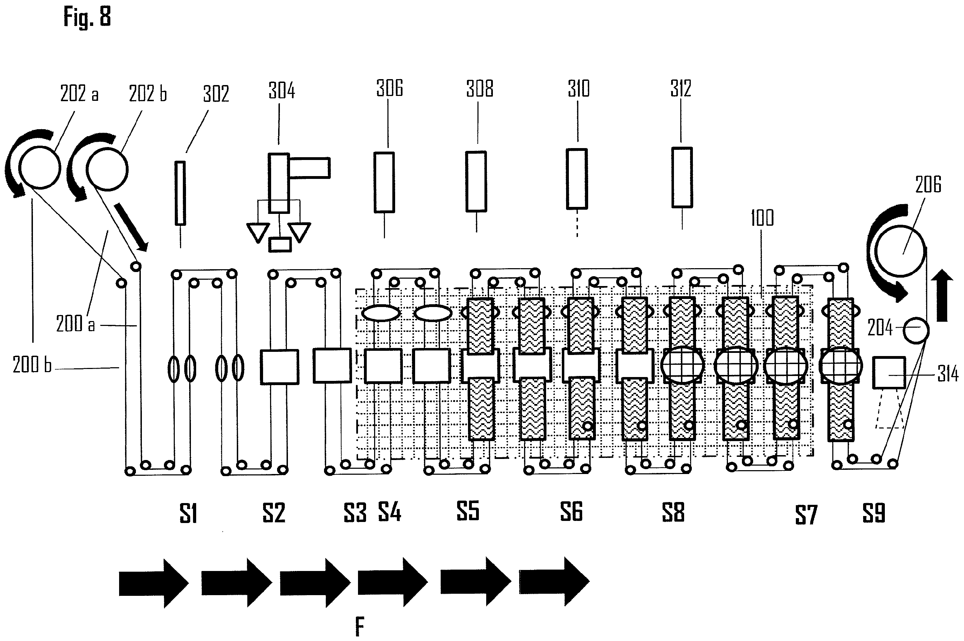

Hierzu werden die Antennendrähte 200a, 200b von den Verlegearmen der Verlegeeinrichtung jeweils in einer Draufsicht U-förmig (siehe auch die folgenden Fig. 7 und 8) und unter einer Materialspannung um die paarweise angeordneten Antennendrahtaufnehmer 404 angeordnet, sodass sich insgesamt eine mäanderförmige Anordnung der Antennendrähte 200a, 200b an bzw. zwischen den Drahtfördereinheiten 402a, 402b ergibt. Die Antennendrahtaufnehmer 404 sind im gezeigten Beispiel an den Drahtfördereinheiten 402a, 402b, welche im konkreten Beispiel als in der Förderrichtung F (bzw. im Uhrzeigersinn) umlaufende Förderketten ausgestaltet sind, befestigte L-förmige Aufnahmehaken. Die Antennendrahtaufnehmer 404 stehen von den Drahtfördereinheiten 402a, 402b (bzw. den umlaufenden Förderketten) radial ab und sind jeweils paarweise in regelmäßigen Abständen derart an den Drahtfördereinheiten 402a, 402b bzw. den umlaufenden Förderketten angeordnet, dass die bereitgestellten Antennendrähte 200a, 200b jeweils parallel zueinander einen Innenraum zwischen den Drahtfördereinheiten 402a, 402b überspannen.

Die Drahtfördereinheiten 402a, 402b bzw. die umlaufenden Förderketten fördern die gespannten/aufgespannten bzw. die unter einer Materialspannung U-förmig um die paarweise angeordneten Antennendrahtaufnehmer 404 angeordneten Antennendrähte 200a, 200b taktweise in der Förderrichtung F.

Die gespannten bzw. unter einer Materialspannung angeordneten Antennendrähte 200a, 200b sind hierbei zueinander zumindest abschnittsweise parallel und in einem Winkel, zum Beispiel in einem Winkel von ca. 90°, zur Förderrichtung F angeordnet/gespannt/aufgespannt.

Weiter können die Drahtfördereinheiten 402a, 402b bzw. die umlaufenden Förderketten einen automatisch oder manuell veränderbaren Abstand zueinander aufweisen. Hierdurch kann eine Länge der in einem Winkel zur Förderrichtung F angeordneten/gespannten/aufgespannten Antennendrahtabschnitte eingestellt und/oder justiert werden und/oder eine Materialspannung der Antennendrahtabschnitte erhöht oder verringert werden.

Oberhalb der in der Förderrichtung F geförderten zueinander parallelen Antennendrahtabschnitte befinden sich die Bearbeitungsstationen 302 bis 312. Im Einzelnen zeigt die Fig. 5 schematisch einen Flussmittelspender 302, eine Bestückungsvorrichtung 304 mit integrierter Lötvorrichtung zur Anordnung von Transponderchips, eine Verbindungsvorrichtung 306 zur elektrischen Kontaktierung der geförderten Antennendrähte 200a und 200b und eine Isolationsvorrichtung 308 zum Auftragen einer Isolationslackierung auf die Antennendrähte 200a und 200b. Zudem umfasst die Vorrichtung 2000 weiter eine Laser-Trennvorrichtung 310, welche dazu angeordnet und ausgebildet ist, einen der Antennendrähte 200a, 200b mit einem Laser zu durchtrennen, und eine Versiegelungsvorrichtung 312, welche eine Schutzversiegelung auf den Transponderchip, der zwischen den Antennendrähten angeordnet wurde, aufzutragen. Die Funktionen der einzelnen Bearbeitungsstationen wird im Zusammenhang mit den folgenden Figuren näher erläutert.

Nachdem die unter einer Materialspannung an/auf den Drahtfördereinheiten 402a, 402b angeordneten Antennendrähte 200a, 200b in der Förderrichtung F an der letzten vorgesehenen Bearbeitungsstation (im gezeigten Beispiel die Versiegelungsvorrichtung 312) vorbeigefördert wurden, werden die Antennendrähte 200a, 200b mit den gefertigten Transponderanordnungen im gezeigten Beispiel von einer Abnehmereinrichtung (nicht gezeigt) von den Drahtfördereinheiten 402a, 402b gelöst und an einer Inspektionsvorrichtung 314 vorbei über eine Umlenkrolle 204 zu einer gemeinsamen Aufnahmerolle 206 gefördert. Die Abnehmereinrichtung ist hierbei optional und ausdrücklich nicht in allen Ausführungsformen notwendig. Insbesondere können die Drahtfördereinheiten 402a ,402b und/oder Aufnehmer 404 der Drahtfördereinheiten 402a ,402b derart ausgestaltet sein, dass diese die Antennendrähte 200a, 200b an einer vorbestimmten (Förder-)Position freigeben.

Die Inspektionsvorrichtung 314 überprüft mit optischen und elektronischen Sensoren bzw. Auslesevorrichtungen, ob die gefertigten Transponderanordnungen vorbestimmten Qualitätsanforderungen entsprechen.

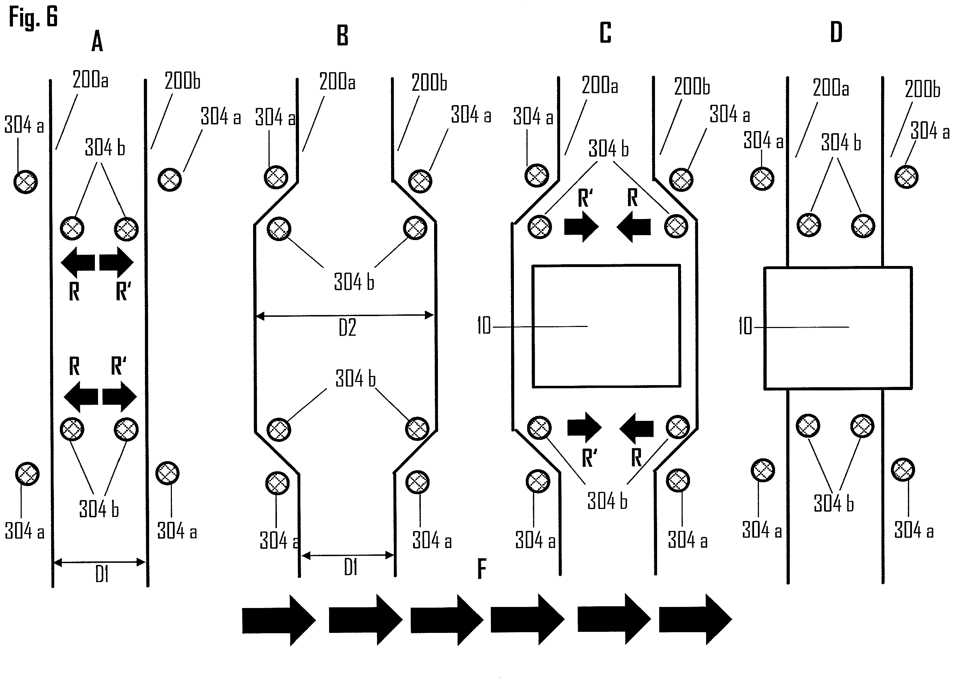

Fig. 6 zeigt schematisch die Anordnung eines Transponderchips 10 zwischen den Antennendrähten 200a, 200b durch die Bestückungsvorrichtung 304. Fig. 6 zeigt die abschnittsweise zueinander parallel geförderten Antennendrähte 200a, 200b in einer Draufsicht bzw. in einer im Vergleich zu Fig. 5 um 90° gedrehten Perspektive.

In einem ersten Schritt (A) werden vier Abstandsstifte 304b aus einer Ruhelage oberhalb der taktweise geförderten parallelen Antennendrähte 200a, 200b bzw. parallelen Antennendrahtabschnitte in den Bereich zwischen die Antennendrähte 200a, 200b bzw. parallelen Antennendrahtabschnitte hinein abgesenkt. Die Abstandsstifte 304b sind im gezeigten Beispiel jeweils paarweise angeordnet bzw. symmetrisch zu den Antennendrähten 200a, 200b angeordnet. Mit anderen Worten kann beschrieben werden, dass die vier Abstandsstifte 304b im Bereich zwischen den Antennendrähten 200a, 200b gemeinsam die Eckpunkte eines Rechtecks definieren, wobei die Antennendrähte 200a, 200b jeweils parallel zu zwei Seiten des Rechtecks verlaufen.

Weiter werden im in Fig. 6 gezeigten Beispiel vier Unterstützungsstifte 304a aus einer Ruhelage oberhalb der taktweise parallel geförderten Antennendrähte 200a, 200b bzw. parallelen Antennendrahtabschnitte in den Bereich außerhalb des von den Antennendrähten 200a, 200b umformten Innenraums abgesenkt. Die Unterstützungsstifte 304a sind im gezeigten Beispiel ebenfalls jeweils paarweise angeordnet bzw. symmetrisch zu den Antennendrähten 200a, 200b angeordnet. Mit anderen Worten kann beschrieben werden, dass die vier Unterstützungsstifte 304a gemeinsam die Eckpunkte eines Rechtecks definieren, wobei die Antennendrähte 200a, 200b jeweils parallel zu zwei Seiten des Rechtecks verlaufen.

Nachdem die Unterstützungsstifte 304a und die Abstandsstifte 304b abgesenkt sind, werden die Abstandsstifte 304b jeweils in einer Richtung R sowie in einer Gegenrichtung R' bewegt. Die Richtung R und die Gegenrichtung R' verlaufen hierbei, in einer Draufsicht auf die parallelen Antennendrähte 200a, 200b, jeweils parallel zur Förderrichtung F der in Fig. 5 gezeigten Vorrichtung.

Die parallelen Antennendrähte 200a, 200b bzw. parallelen Antennendrahtabschnitte werden von der in Fig. 6 gezeigten Vorrichtung in einem Abstand D1 zueinander parallel gefördert. Fig. 6 zeigt weiter, dass die Bestückungsvorrichtung 304 in einem zweiten Schritt (B) den Abstand der Antennendrähte 200a, 200b temporär und lokal bis zu einem Bestückungsabstand D2 erhöht, indem die Abstandsstifte 304b jeweils in einer Richtung R sowie in einer Gegenrichtung R' bewegt werden. Die Unterstützungsstifte 304a bewirken hierbei, dass die Vergrößerung des Abstands der Antennendrähte 200a, 200b im Wesentlichen lokal begrenzt wird, sodass sich die Antennendrähte 200a, 200b nicht unbeabsichtigt von den Antennendrahtaufnehmern 404 lösen.

Weiter zeigt Fig. 6, dass die Bestückungsvorrichtung 304 in einem dritten Schritt (C) einen Transponderchip 10 zwischen den Antennendrähten 200a, 200b im Bereich des temporär erhöhten Bestückungsabstands D2 anordnet. Das Anordnen des Transponderchips 10, welcher an zwei einander gegenüberliegenden und den Antennendrähten 200a, 200b jeweils zugewandten Seitenflächen Vertiefungen zur Aufnahme der Antennendrähte 200a, 200b aufweist, kann zum Beispiel mit einem Vakuumgreifer (nicht gezeigt) oder einer anderen Vorrichtung zur Handhabung von Transponderchips geschehen. Nachdem der Transponderchip 10 zwischen den Antennendrähten 200a, 200b positioniert ist, werden die Abstandsstifte 304b jeweils entgegen der Richtung, in der sie zur temporären Veränderung des Abstandes der Antennendrähte bewegt wurden, zurückbewegt, bis in einem vierten Schritt (D) die Antennendrähte 200a, 200b in Anlage mit den Vertiefungen des Transponderchips angeordnet sind. Die Bestückungsvorrichtung hebt nun die Unterstützungsstifte 304a und die Abstandsstifte 304b an, bis diese wieder in der Ruhelage oberhalb der taktweise parallel geförderten Antennendrähte 200a, 200b bzw. oberhalb der Antennendrahtabschnitte positioniert sind, sodass ein Förderweg entlang der Förderrichtung F für die Antennendrähte 200a, 200b bzw. Antennendrahtabschnitte und den zwischen ihnen angeordneten Transponderchip 10 freigegeben ist. Anschließend werden die parallelen Antennendrähte 200a, 200b und der zwischen ihnen angeordnete Transponderchip 10 entlang der Förderrichtung F gefördert.

Fig. 7 zeigt schematisch eine schrittweise Fertigung einer Transponderanordnung mit einer Vorrichtung nach Fig. 5. Gleichzeitig verdeutlicht Fig. 7, dass sich bei einer Vorrichtung nach Fig. 5 jeweils Transponderanordnungen unterschiedlicher Fertigungsstadien an den quasiendlos bereitgestellten Antennendrähten 200a, 200b bzw. an den zueinander parallelen Antennendrahtabschnitten befinden können. Die in unterschiedlichen Fertigungsstadien befindlichen Transponderanordnungen werden jeweils taktweise von einer Fertigungsstation zu einer weiteren Fertigungsstation gefördert, wobei jede Fertigungsstation zumindest einen Bearbeitungsvorgang ausführt.

In einem ersten Schritt S1 wird jeweils ein Flussmittel 30a, 30b durch den Flussmittelspender 302 auf die taktweise parallel geförderten Antennendrähte 200a, 200b bzw. auf die parallel geförderten Antennendrahtabschnitte aufgetragen.

In einem zweiten Schritt S2 wird, wie zu Fig. 6 ausführlich beschrieben, ein Transponderchip 10 zwischen den zueinander parallelen Antennendrähten 200a, 200b bzw. den zueinander parallelen Antennendrahtabschnitten angeordnet. Ferner wird der Transponderchip 10 mit den Antennendrähten 200a, 200b verlötet, sodass eine elektrisch leitende Verbindung zwischen den Antennendrähten 200a, 200b und den Kontakten 18a, 18b des Transponderchips 10 (nicht in Fig. 7 gezeigt, siehe Fig. 1) hergestellt ist.

In einem vierten Schritt S4 wird durch die Verbindungsvorrichtung 306 eine elektrisch leitende Verbindung 201 zwischen den Antennendrähten 200a, 200b hergestellt.

In einem fünften Schritt S5 wird durch die Isolationsvorrichtung 308 eine elektrische Isolierung 32 bzw. ein Dielektrikum auf einen Teil der geförderten Antennendrähte 200a, 200b und auf einen Teil des Transponderchips 10 aufgebracht. Die Isolierung 32 wird mittels UV-Licht angetrocknet bzw. ausgehärtet.

In einem optionalen sechsten Schritt S6 wird einer der geförderten Antennendrähte 200a und ein Teil der aufgebrachten Isolierung 34 von einer Laser-Trennvorrichtung 310 durchtrennt. Hierdurch entsteht eine Ausnehmung/Auslassung 34 in der Isolierung und in einem der Antennendrähte 200a. Hierdurch kann eine Transponderanordnung mit ungleichartig ausgestalteten Antennenenden hergestellt werden.

In einem achten Schritt S8 wird durch die Versiegelungsvorrichtung 312 eine Versiegelung 36 auf den Transponderchip 10 und auf einen Teil der Isolierung 34 aufgetragen. Die Versiegelung 36 wird ebenfalls mittels UV-Licht angetrocknet bzw. ausgehärtet.

In einem neunten Schritt S9 wird die Funktionsfähigkeit der gefertigten Transponderanordnung mit einer Inspektionsvorrichtung 314 überprüft,

Fig. 8 zeigt analog die bereits in Fig. 7 schematisch dargestellten Fertigungsstadien einer Transponderanordnung. Abweichend zu der in den Fig. 5 und 7 dargestellten Fertigungsanordnung bzw. Fertigungsvorrichtung 2000 weist die in Fig. 8 dargestellte Fertigungsanordnung jedoch noch zusätzlich ein Silikonpapier 100 auf, über das die zueinander parallelen Antennendrahtabschnitte der Antennendrähte 200a, 200b geführt werden. Die Antennendrähte 200a, 200b befinden sich vom Fertigungsschritt S3 bis zum Fertigungsschritt S7 in Anlage mit dem Silikonpapier 100.

In einer Weiterbildung kann das Silikonpapier 100, welches als streifenförmiges quasi-endloses Silikonpapier 100 bereitgestellt werden kann, analog zu den Antennendrähten 200a, 200b in der Förderrichtung F gefördert werden, sodass die Antennendrähte 200a, 200b bzw. die in verschiedenen Fertigungsstadien befindlichen Transponderanordnungen keine oder zumindest annähernd keine Relativbewegung/Relativgeschwindigkeit aufweisen. Optional können das Silikonpapier 100 und/oder die Antennendrähte 200a, 200b bzw. die zueinander parallelen Antennendrahtabschnitte über eine in Richtung der Förderrichtung F konvexe und/oder in einer Richtung orthogonal zur Förderrichtung F konvexe Gleitfläche (nicht gezeigt) gefördert werden.

Im Einzelnen zeigt Fig. 8 die folgenden Schritte bzw. Fertigungsstadien der Transponderstationen:
In einem ersten Schritt S1 wird jeweils ein Flussmittel 30a, 30b durch den Flussmittelspender 302 auf die taktweise parallel geförderten Antennendrähte 200a, 200b bzw. auf die parallel geförderten Antennendrahtabschnitte aufgetragen.

In einem zweiten Schritt S2 wird, wie zu Fig. 6 ausführlich beschrieben, ein Transponderchip 10 zwischen den zueinander parallelen Antennendrähten 200a, 200b bzw. den zueinander parallelen Antennendrahtabschnitten angeordnet. Ferner wird der Transponderchip 10 mit den Antennendrähten 200a, 200b verlötet, sodass eine elektrisch leitende Verbindung zwischen den Antennendrähten 200a, 200b und den Kontakten 18a, 18b des Transponderchips 10 (nicht in Fig. 8 gezeigt, siehe Fig. 1) hergestellt ist.

In einem dritten Schritte S3 werden die Antennendrähte 200a, 200b bzw. zueinander parallelen Antennendrahtabschnitte weiter taktweise entlang der Förderrichtung F gefördert, bis die parallelen Antennendrahtabschnitte und der mit ihnen verlötete Transponderchip 10 in Anlage mit dem Silikonpapier 100 angeordnet sind, welches optional taktweise und mit der gleichen Fördergeschwindigkeit wie die Antennendrähte 200a, 200b gefördert wird.

In einem vierten Schritt S4 wird durch die Verbindungsvorrichtung 306 eine elektrisch leitende Verbindung 201 zwischen den Antennendrähten 200a, 200b hergestellt.

In einem fünften Schritt S5 wird durch die Isolationsvorrichtung 308 eine elektrische Isolierung 32 bzw. ein Dielektrikum auf einen Teil der geförderten Antennendrähte 200a, 200b und auf einen Teil des Transponderchips 10 aufgebracht. Die Isolierung 32 wird mittels UV-Licht angetrocknet bzw. ausgehärtet.

In einem optionalen sechsten Schritt S6 wird einer der geförderten Antennendrähte 200a und ein Teil der aufgebrachten Isolierung 34 von einer Laser-Trennvorrichtung 310 durchtrennt. Hierdurch entsteht eine Ausnehmung/Auslassung 34 in der Isolierung und in einem der Antennendrähte 200a. Hierdurch kann eine Transponderanordnung mit ungleichartig ausgestalteten Antennenenden hergestellt werden.

In einem achten Schritt S8 wird durch die Versiegelungsvorrichtung 312 eine Versiegelung 36 auf den Transponderchip 10 und auf einen Teil der Isolierung 34 aufgetragen. Die Versiegelung 36 wird ebenfalls mittels UV-Licht angetrocknet bzw. ausgehärtet.

In einem siebten Schritt S7 werden die Antennendrähte 200a, 200b bzw. zueinander parallelen Antennendrahtabschnitte weiter taktweise entlang der Förderrichtung F gefördert, bis die Antennendrähte 200a, 200b und der mit ihnen verlötete Transponderchip 10 nicht mehr in Anlage mit dem Silikonpapier 100 angeordnet sind.

In einem neunten Schritt S9 wird die Funktionsfähigkeit der gefertigten Transponderanordnung mit einer Inspektionsvorrichtung 314 überprüft.

Es versteht sich, dass die zuvor erläuterten beispielhaften Ausführungsformen nicht abschließend sind und den hier offenbarten Gegenstand nicht beschränken. Insbesondere ist für den Fachmann ersichtlich, dass er die beschriebenen Merkmale beliebig miteinander kombinieren kann und/oder verschiedene Merkmale weglassen kann, ohne dabei von dem hier offenbarten Gegenstand abzuweichen.

## Patentansprüche

1. Vorrichtung (2000) zur Herstellung von RFID-Transpondern, aufweisend
- eine Drahtfördervorrichtung (202a, 202b, 204, 206) mit zumindest zwei Drahtfördereinheiten (402a, 402b), die dazu angeordnet und ausgebildet sind, zumindest zwei Antennendrähte (200a, 200b) in einer Förderrichtung (F) zu fördern, wobei
die Drahtfördereinheiten (402a, 402b) weiter dazu angeordnet und ausgebildet sind, im Zusammenwirken die zumindest zwei Antennendrähte (200a, 200b) zueinander zumindest abschnittsweise parallel in einem Winkel von im Wesentlichen 90° zur Förderrichtung (F) zu spannen, sodass die abschnittsweise zueinander parallelen Antennendrähte (200a, 200b) eine Materialspannung in einem Winkel von im Wesentlichen 90° zur Förderrichtung (F) aufweisen; und
- zumindest eine Bestückungsvorrichtung (304), die dazu angeordnet und ausgebildet ist, einen Transponderchip (10; 20) zwischen den in einem Winkel von im Wesentlichen 90° zur Förderrichtung (F) gespannten Antennendrähten (200a, 200b) anzuordnen.

2. Vorrichtung nach dem vorangegangenen Anspruch, wobei
die Drahtfördereinheiten (402a, 402b) gemeinsam einen Innenraum umformen, und/oder
ein Abstand der Drahtfördereinheiten (402a, 402b) zueinander veränderbar ist, und/oder
die Drahtfördereinheiten (402a, 402b) als in der Förderrichtung (F) umlaufende Fördervorrichtungen, insbesondere als in der Förderrichtung (F) umlaufende Förderbänder oder als in der Förderrichtung (F) umlaufende Förderketten, ausgestaltet sind, und/oder
die Drahtfördereinheiten (402a, 402b) eine Vielzahl von Antennendrahtaufnehmern (404) und/oder eine Vielzahl von Antennendrahtaufnehmerpaaren aufweisen, und/oder
die Antennendrahtaufnehmer (404) und/oder die Antennendrahtaufnehmerpaare jeweils in einem regelmäßigen Abstand zueinander an den Drahtfördereinheiten (402a, 402b) angeordnet sind, und/oder
die Antennendrahtaufnehmer (404) und/oder die Antennendrahtaufnehmerpaare jeweils dazu angeordnet und ausgebildet sind, jeweils mit einem Antennendraht (200a, 200b) in Anlage gebracht zu werden, wobei der Antennendraht eine Materialspannung aufweist, und/oder
die Antennendrahtaufnehmer (404) und/oder die Antennendrahtaufnehmerpaare dazu angeordnet und ausgebildet sind, jeweils im Zusammenwirken einen Abschnitt der Antennendrähte (200a, 200b) zu spannen, sodass der Abschnitt der Antennendrähte (200a, 200b) jeweils eine Materialspannung aufweist.

3. Vorrichtung nach einem der vorangegangenen Ansprüche, wobei
die Drahtfördervorrichtung (202a, 202b, 204, 206) eine oder mehrere Bereitstellungsrollen (202a, 202b) und/oder eine oder mehrere Umlenkrollen (204) und/oder eine Aufnahmerolle (206) aufweist.

4. Vorrichtung nach einem der vorangegangenen Ansprüche, weiter aufweisend
- eine Verlegevorrichtung, die dazu angeordnet und ausgebildet ist, die zumindest zwei Antennendrähte (200a, 200b) jeweils mit einem Antennendrahtaufnehmer (404) einer Drahtfördereinheit (402a, 402b) und/oder mit einem Antennendrahtaufnehmerpaar einer Drahtfördereinheit (402a, 402b) in Anlage zu bringen, sodass die Antennendrähte (200a, 200b) zwischen zwei jeweils voneinander beabstandeten Antennendrahtaufnehmern (404) oder Antennendrahtaufnehmerpaaren eine Materialspannung aufweisen.

5. Vorrichtung (1000) zur Herstellung von RFID-Transpondern, aufweisend
- eine Gleitfläche, und
- eine Drahtfördervorrichtung (202a, 202b, 204, 206), die dazu angeordnet und ausgebildet sind, zumindest zwei Antennendrähte (200a, 200b) über die Gleitfläche hinweg in einer Förderrichtung (F) zu fördern, wobei
die Drahtfördervorrichtung weiter dazu angeordnet und ausgebildet ist, im Zusammenwirken mit der Gleitfläche die zumindest zwei Antennendrähte (200a, 200b) zueinander zumindest abschnittsweise parallel zu spannen, sodass die abschnittsweise zueinander parallelen Antennendrähte (200a, 200b) eine Materialspannung längs der Förderrichtung (F) aufweisen; und
- zumindest eine Bestückungsvorrichtung (304), die dazu angeordnet und ausgebildet ist, einen Transponderchip (10; 20) zwischen den in längs der Förderrichtung (F) gespannten Antennendrähten (200a, 200b) anzuordnen.

6. Vorrichtung nach dem vorangegangenen Anspruch, weiter aufweisend
- zumindest eine Unterlagenfördervorrichtung (104, 106, 108), die dazu angeordnet und ausgebildet ist, eine Verarbeitungsunterlage (100), insbesondere ein Silikonpapier, in der Förderrichtung (F) zwischen der Gleitfläche (102) und den Antennendrähten (200a, 200b) zu fördern, und/oder wobei
die Unterlagenfördervorrichtung (104, 106, 108) eine Unterlagenbereitstellungsrolle (104) und/oder eine oder mehrere Umlenkrollen (106) und/oder eine Unterlagenaufnahmerolle aufweist, und/oder
die Unterlagenfördervorrichtung (104, 106, 108) ferner dazu angeordnet und ausgebildet ist, die Verarbeitungsunterlage (100) im Zusammenwirken mit der Gleitfläche (102) zu spannen, sodass die Verarbeitungsunterlage (100) eine Materialspannung in der Förderrichtung (F) aufweist, und/oder wobei
die Unterlagenfördervorrichtung (104, 106, 108) die Verarbeitungsunterlage (100) und die Drahtfördervorrichtung (202a, 202b, 204, 206) mit den Drahtfördereinheiten (402a, 402b) die Antennendrähte (200a, 200b) jeweils mit derselben Fördergeschwindigkeit fördern, und/oder wobei
die Unterlagenfördervorrichtung (104, 106, 108) die Verarbeitungsunterlage (100) und die Drahtfördervorrichtung (202a, 202b, 204, 206) mit den Drahtfördereinheiten (402a, 402b) die Antennendrähte (200a, 200b) jeweils taktweise fördern, und/oder wobei
die Unterlagenfördervorrichtung (104, 106, 108) mit den Drahtfördereinheiten (402a, 402b) ferner dazu angeordnet und ausgebildet ist, die Verarbeitungsunterlage (100) in zumindest abschnittsweise Anlage mit der Gleitfläche (102) anzuordnen und die Verarbeitungsunterlage (100) mit einer Gleitreibung über die Gleitfläche (102) zu fördern, und/oder wobei
die Drahtfördervorrichtung (202a, 202b, 204, 206) mit den Drahtfördereinheiten (402a, 402b) dazu angeordnet und ausgebildet ist, die Antennendrähte (200a, 200b) zumindest abschnittsweise in Anlage mit der Gleitfläche (102) anzuordnen und die Antennendrähte (200a, 200b) mit einer Gleitreibung über die Gleitfläche (102) zu fördern, oder wobei
die Drahtfördervorrichtung (202a, 202b, 204, 206) mit den Drahtfördereinheiten (402a, 402b) dazu angeordnet und ausgebildet ist, die Antennendrähte (200a, 200b) zumindest abschnittsweise in Anlage mit der Verarbeitungsunterlage (100) anzuordnen.

7. Vorrichtung nach einem der vorangegangenen Ansprüche, wobei
die Bestückungsvorrichtung (304) dazu angeordnet und ausgebildet ist, einen Abstand (D1) der zumindest abschnittsweise zueinander parallel geförderten Antennendrähte (200a, 200b) temporär lokal zu verändern, sodass die Antennendrähte (200a, 200b) im Bereich der Bestückungsvorrichtung (304) temporär einen Bestückungsabstand (D2) zueinander aufweisen, der größer ist als der Abstand (D1) der zumindest abschnittsweise zueinander parallelen Antennendrähte (200a, 200b) außerhalb des Bereichs der Bestückungsvorrichtung (304), und/oder wobei
die Bestückungsvorrichtung (304) ein oder mehrere Abstandsveränderungselement/e, insbesondere Abstandsstifte (304b), aufweist, die
i) parallel zu einer Flächennormalen einer durch die zumindest abschnittsweise zueinander parallelen Antennendrähte (200a, 200b) verlaufenden Ebene absenkbar und anhebbar sind, wobei die Abstandsveränderungselemente in einem abgesenkten Zustand zwischen den geförderten Antennendrähten (200a, 200b) angeordnet sind und in einem angehobenen Zustand nicht zwischen den Antennendrähten (200a, 200b) angeordnet sind, und/oder die
ii) jeweils in einer Richtung (R) und in einer der Richtung entgegengesetzten Gegenrichtung (R') beweglich sind, wobei die Richtung (R) und die Gegenrichtung (R') jeweils parallel zur Förderrichtung (F) und orthogonal zur Flächennormalen der durch die zumindest abschnittsweise zueinander parallelen Antennendrähte (200a, 200b) verlaufenden Ebene sind.

8. Vorrichtung nach einem der vorangegangenen Ansprüche, ferner aufweisend
- einen Flussmittelspender (302) der dazu angeordnet und ausgebildet ist, jeweils ein Flussmittel (30a, 30b) auf die Antennendrähte (200a, 200b) aufzutragen; und/oder
- eine Lötvorrichtung, die dazu angeordnet und ausgebildet ist, jeweils ein Lot auf die Antennendrähte (200a, 200b) und/oder auf einen Transponderchip (10; 20) aufzubringen und die Antennendrähte (200a, 200b) mit einem zwischen ihnen angeordneten Transponderchip (10; 20) zu verlöten; und/oder
- eine Verbindungsvorrichtung (306), die dazu angeordnet und ausgebildet ist, eine elektrisch leitende Verbindung (201) zwischen den Antennendrähten (200a, 200b) herzustellen; und/oder
- eine Isolationsvorrichtung (308) die dazu angeordnet und ausgebildet ist, zumindest einen Teil der Antennendrähte (200a, 200b) und/oder zumindest einen Teil der elektrisch leitenden Verbindung (201) mit einem Isolationsmaterial (32) zu umgeben; und/oder
- eine Trennvorrichtung (310), insbesondere eine Laser-Trennvorrichtung, die dazu angeordnet und ausgebildet ist, zumindest einen Teil der Antennendrähte (200a, 200b) und/oder zumindest einen Teil des Isolationsmaterials (32) zu durchtrennen; und/oder
- eine Versiegelungsvorrichtung (312), die dazu angeordnet und ausgebildet ist, eine Versiegelung (36) zumindest auf einen Teil des Transponderchips (10; 20) und/oder zumindest einen Teil des Isolationsmaterials (32) und oder zumindest einen Teil der Antennendrähte (200a, 200b) aufzutragen; und/oder
- eine Inspektionsvorrichtung (314), die dazu angeordnet und ausgebildet ist, Eigenschafts- und/oder Positionierungsfehler eines Transponderchips (10; 20) und/oder einer Transponderanordnung zu ermitteln; und/oder
- eine Vereinzelungsvorrichtung, die dazu angeordnet und ausgebildet ist, die Antennendrähte (200a, 200b) und/oder das Isolationsmaterial (32) jeweils zu durchtrennen, sodass jeweils eine vereinzelte Transponderanordnung mit zumindest einem Transponderchip (10; 20) und zumindest einer Antennenanordnung, insbesondere einer Schleifenantenne, entsteht, wobei
die Antennenanordnung, insbesondere die Schleifenantenne, der Transponderanordnung einen Abschnitt der durchtrennten Antennendrähte (200a, 200b) und/oder der elektrisch leitenden Verbindung (201) umfasst.

9. Verfahren zur Herstellung von RFID-Transpondern, aufweisend die Schritte:
- Bereitstellen von zumindest zwei Antennendrähten (200a, 200b), die von einer Drahtfördervorrichtung (202a, 202b, 204, 206) mit zumindest zwei Drahtfördereinheiten (402a, 402b) in einer Förderrichtung (F) gefördert werden, wobei
die Drahtfördereinheiten (402a, 402b) dazu angeordnet und ausgebildet sind, im Zusammenwirken die Antennendrähte (200a, 200b) zueinander zumindest abschnittsweise parallel und in einem Winkel von im Wesentlichen 90° zur Förderrichtung (F) zu spannen, sodass die abschnittsweise zueinander parallelen Antennendrähte (200a, 200b) eine Materialspannung in einem Winkel von im Wesentlichen 90° zur Förderrichtung (F) aufweisen; und
- Anordnen (S2) eines Transponderchips (10; 20) zwischen den zueinander zumindest abschnittsweise parallelen und in einem Winkel von im Wesentlichen 90° zur Förderrichtung (F) gespannten Antennendrähten (200a, 200b).

10. Verfahren nach dem vorangegangenen Anspruch, ferner aufweisend zumindest einen der Schritte:
- Auftragen (S1) eines Flussmittelauftrags (30) auf die Antennendrähte (200a, 200b); und/oder
- Aufbringen eines Lots auf die Antennendrähte (200a, 200b) und/oder auf einen Transponderchip (10; 20) und Verlöten der zumindest abschnittsweise zueinander parallelen Antennendrähte (200a, 200b) mit einem zwischen den Antennendrähten (200a, 200b) angeordneten Transponderchip (10; 20); und/oder
- Herstellen (S4) zumindest einer elektrisch leitenden Verbindung (201) zwischen den zumindest zwei Antennendrähten (200a, 200b); und/oder
- Umgeben (S5) zumindest eines Teils der Antennendrähte (200a, 200b) und/oder zumindest eines Teils der elektrisch leitenden Verbindung (201) mit einem Isolationsmaterial (32); und/oder
- Durchtrennen (S6) zumindest eines Teils der Antennendrähte (200a, 200b) und/oder zumindest eines Teils des Isolationsmaterials (32); und/oder
- Auftragen (S8) einer Versiegelung (36) zumindest auf einen Teil des Transponderchips (10; 20) und/oder auf das Isolationsmaterial (32) und/oder auf die Antennendrähte (200a, 200b); und/oder
- Ermitteln (S9) von Eigenschafts- und/oder Positionierungsfehlern eines Transponderchips (10; 20) und/oder einer Transponderanordnung.

## Claims

1. An apparatus (2000) for manufacturing RFID transponders, comprising
- a wire conveying device (202a, 202b, 204, 206) having at least two wire conveying units (402a, 402b) which are arranged and designed to convey at least two antenna wires (200a, 200b) in a conveying direction (F), wherein
said wire conveying units (402a, 402b) being further arranged and adapted to cooperate in tensioning said at least two antenna wires (200a, 200b) at least in sections parallel to each other at an angle of substantially 90° to said conveying direction (F), so that said antenna wires (200a, 200b) parallel to each other in sections have a material tension at an angle of substantially 90° to said conveying direction (F); and
- at least one placement device (304) being arranged and adapted to place a transponder chip (10; 20) between the antenna wires (200a, 200b) tensioned at an angle of substantially 90° to the conveying direction (F).

2. The apparatus according to the preceding claim, wherein
the wire conveying units (402a, 402b) jointly form an inner space, and/or
a distance between the wire conveying units (402a, 402b) is variable, and/or
the wire conveying units (402a, 402b) are designed as conveying devices circulating in the conveying direction (F), in particular as conveyor belts circulating in the conveying direction (F) or as conveyor chains circulating in the conveying direction (F), and/or
the wire conveying units (402a, 402b) comprise a plurality of antenna wire pick-ups (404) and/or a plurality of antenna wire pick-up pairs, and/or
the antenna wire pick-ups (404) and/or the antenna wire pick-up pairs are each arranged at a regular distance from each other on the wire conveying units (402a, 402b), and/or
the antenna wire pick-ups (404) and/or the antenna wire pick-up pairs are each arranged and adapted to be brought into contact with a respective antenna wire (200a, 200b), the antenna wire having a material tension, and/or
said antenna wire pickups (404) and/or said antenna wire pickup pairs are each arranged and adapted to cooperatively tension a portion of said antenna wires (200a, 200b) such that said portion of said antenna wires (200a, 200b) each has a material tension.

3. The apparatus according to any one of the preceding claims, wherein
the wire conveying device (202a, 202b, 204, 206) comprises one or more supply rollers (202a, 202b) and/or one or more return rollers (204) and/or a take-up roller (206).

4. The apparatus according to any one of the preceding claims, further comprising
- a laying device arranged and configured to bring the at least two antenna wires (200a, 200b) each into contact with an antenna wire receiver (404) of a wire conveying unit (402a, 402b) and/or with a pair of antenna wire receivers of a wire conveying unit (402a, 402b) so that the antenna wires (200a, 200b) have a material tension between two antenna wire pickups (404) or pairs of antenna wire receivers respectively spaced apart from each other.

5. The apparatus (1000) for producing RFID transponders, comprising
- a sliding surface, and
- a wire conveying device (202a, 202b, 204, 206) arranged and adapted to convey at least two antenna wires (200a, 200b) across the sliding surface in a conveying direction (F), wherein
the wire conveying device is further arranged and adapted to tension the at least two antenna wires (200a, 200b) in cooperation with the sliding surface parallel to each other at least in sections, so that the antenna wires (200a, 200b) parallel to each other in sections have a material tension along the conveying direction (F); and
- at least one placement device (304) arranged and adapted to place a transponder chip (10; 20) between the antenna wires (200a, 200b) tensioned along the conveying direction (F).

6. The apparatus according to the preceding claim, further comprising
- at least one pad conveying device (104, 106, 108) arranged and adapted to convey a processing pad (100), in particular a silicone paper, in the conveying direction (F) between the sliding surface (102) and the antenna wires (200a, 200b), and/or wherein
the document conveying device (104, 106, 108) comprises a document supply roller (104) and/or one or more deflection rollers (106) and/or a document receiving roller, and/or
the pad conveying device (104, 106, 108) is further arranged and configured to tension the processing pad (100) in cooperation with the sliding surface (102) so that the processing pad (100) has a material tension in the conveying direction (F), and/or wherein
the underlay conveying device (104, 106, 108) conveys the processing underlay (100) and the wire conveying device (202a, 202b, 204, 206) with the wire conveying units (402a, 402b) conveys the antenna wires (200a, 200b) in each case at the same conveying speed, and/or wherein
the base conveying device (104, 106, 108) conveys the processing base (100) and the wire conveying device (202a, 202b, 204, 206) with the wire conveying units (402a, 402b) conveys the antenna wires (200a, 200b) in each case cyclically, and/or wherein
the pad conveying device (104, 106, 108) with the wire conveying units (402a, 402b) is further arranged and configured to arrange the processing pad (100) in at least partial abutment with the sliding surface (102) and to convey the processing pad (100) with a sliding friction over the sliding surface (102), and/or wherein
the wire conveying device (202a, 202b, 204, 206) with the wire conveying units (402a, 402b) is arranged and constructed to arrange the antenna wires (200a, 200b) at least in sections in contact with the sliding surface (102) and to convey the antenna wires (200a, 200b) with a sliding friction over the sliding surface (102), or wherein
the wire conveying device (202a, 202b, 204, 206) with the wire conveying units (402a, 402b) is arranged and constructed to arrange the antenna wires (200a, 200b) at least in sections in contact with the processing base (100).

7. The apparatus according to any one of the preceding claims, wherein
the placement device (304) is arranged and designed to temporarily locally change a spacing (D1) of the antenna wires (200a, 200b), which are conveyed parallel to one another at least in sections, so that the antenna wires (200a, 200b) in the region of the placement device (304) temporarily have a placement spacing (D2) from one another which is greater than the spacing (D1) of the antenna wires (200a, 200b), which are parallel to one another at least in sections, outside the region of the placement device (304), and/or wherein
the placement device (304) has one or more spacing modification element(s), in particular spacing pins (304b), which are
i) can be lowered and raised parallel to a surface normal of a plane running through the antenna wires (200a, 200b) which are parallel to one another at least in sections, the distance-changing elements being arranged between the conveyed antenna wires (200a, 200b) in a lowered state and not being arranged between the antenna wires (200a, 200b) in a raised state, and/or the
ii) are each movable in a direction (R) and in an opposite direction (R') opposite to the direction, wherein the direction (R) and the opposite direction (R') are each parallel to the conveying direction (F) and orthogonal to the surface normal of the plane extending through the antenna wires (200a, 200b) which are parallel to one another at least in sections.

8. The apparatus according to any one of the preceding claims, further comprising
- a flux dispenser (302) arranged and configured to apply a flux (30a, 30b) to each of the antenna wires (200a, 200b); and/or
- a soldering device arranged and adapted to apply a solder to each of the antenna wires (200a, 200b) and/or a transponder chip (10; 20) and to solder the antenna wires (200a, 200b) to a transponder chip (10; 20) disposed therebetween; and/or
- a connecting device (306) arranged and adapted to make an electrically conductive connection (201) between the antenna wires (200a, 200b); and/or
- an insulating device (308) arranged and adapted to surround at least part of the antenna wires (200a, 200b) and/or at least part of the electrically conductive connection (201) with an insulating material (32); and/or
- a severing device (310), in particular a laser severing device, arranged and adapted to sever at least a part of the antenna wires (200a, 200b) and/or at least a part of the insulating material (32); and/or
- a sealing device (312) arranged and adapted to apply a seal (36) to at least part of the transponder chip (10; 20) and/or at least part of the insulation material (32) and/or at least part of the antenna wires (200a, 200b); and/or
- an inspection device (314) arranged and adapted to detect property and/or positioning errors of a transponder chip (10; 20) and/or a transponder assembly; and/or
- a separating device which is arranged and designed to cut through the antenna wires (200a, 200b) and/or the insulation material (32) in each case, so that in each case a separated transponder arrangement with at least one transponder chip (10; 20) and at least one antenna arrangement, in particular a loop antenna, is produced, wherein
the antenna arrangement, in particular the loop antenna, of the transponder arrangement comprises a section of the severed antenna wires (200a, 200b) and/or of the electrically conductive connection (201).

9. A method of manufacturing RFID transponders, comprising the steps of:
- providing at least two antenna wires (200a, 200b) which are conveyed by a wire conveying device (202a, 202b, 204, 206) having at least two wire conveying units (402a, 402b) in a conveying direction (F), wherein
the wire conveying units (402a, 402b) are arranged and formed to cooperate in tensioning the antenna wires (200a, 200b) parallel to each other at least in sections and at an angle of substantially 90° to the conveying direction (F), so that the antenna wires (200a, 200b) parallel to each other in sections have a material tension at an angle of substantially 90° to the conveying direction (F); and
- arranging (S2) a transponder chip (10; 20) between the antenna wires (200a, 200b) which are at least partially parallel to each other and tensioned at an angle of substantially 90° to the conveying direction (F).

10. The method according to the preceding claim, further comprising at least one of the steps:
- applying (S1) a flux coating (30) on the antenna wires (200a, 200b); and/or
- applying a solder to the antenna wires (200a, 200b) and/or to a transponder chip (10; 20) and soldering the antenna wires (200a, 200b), which are parallel to one another at least in sections, to a transponder chip (10; 20) arranged between the antenna wires (200a, 200b); and/or
- making (S4) at least one electrically conductive connection (201) between the at least two antenna wires (200a, 200b); and/or
- surrounding (S5) at least part of the antenna wires (200a, 200b) and/or at least part of the electrically conductive connection (201) with an insulating material (32); and/or
- severing (S6) at least a portion of the antenna wires (200a, 200b) and/or at least a portion of the insulating material (32); and/or
- applying (S8) a seal (36) to at least part of the transponder chip (10; 20) and/or to the insulation material (32) and/or to the antenna wires (200a, 200b); and/or
- determining (S9) property and/or positioning errors of a transponder chip (10; 20) and/or a transponder arrangement.

## Revendications

1. Un dispositif (2000) pour la fabrication de transpondeurs RFID, comprenant
- un dispositif de transport de fil (202a, 202b, 204, 206) comprenant au moins deux unités de transport de fil (402a, 402b) qui sont agencées et conçues pour transporter au moins deux fils d'antenne (200a, 200b) dans une direction de transport (F), dans lequel
les unités de transport de fil (402a, 402b) sont en outre disposées et conçues pour tendre en coopération les au moins deux fils d'antenne (200a, 200b) au moins par sections parallèlement l'un à l'autre selon un angle de sensiblement 90° par rapport à la direction de transport (F), de sorte que les fils d'antenne (200a, 200b) parallèles l'un à l'autre par sections présentent une tension de matériau selon un angle de sensiblement 90° par rapport à la direction de transport (F) ; et
- au moins un dispositif de placement (304) qui est agencé et conçu pour placer une puce de transpondeur (10 ; 20) entre les fils d'antenne (200a, 200b) tendus selon un angle de sensiblement 90° par rapport à la direction de transport (F).

2. Le dispositif selon la revendication précédente, dans lequel
les unités de transport de fil (402a, 402b) forment ensemble un espace intérieur, et/ou
une distance entre les unités de transport de fil (402a, 402b) est modifiable, et/ou
les unités de transport de fil (402a, 402b) sont conçues comme des dispositifs de transport tournant dans la direction de transport (F), en particulier comme des bandes transporteuses tournant dans la direction de transport (F) ou comme des chaînes de transport tournant dans la direction de transport (F), et/ou
les unités de transport de fil (402a, 402b) présentent une pluralité de capteurs de fil d'antenne (404) et/ou une pluralité de paires de capteurs de fil d'antenne, et/ou
les capteurs de fil d'antenne (404) et/ou les paires de capteurs de fil d'antenne sont respectivement disposés à une distance régulière les uns des autres sur les unités de transport de fil (402a, 402b), et/ou
les capteurs de fil d'antenne (404) et/ou les paires de capteurs de fil d'antenne sont respectivement disposés et conçus pour être respectivement mis en contact avec un fil d'antenne (200a, 200b), le fil d'antenne présentant une tension de matériau, et/ou
les capteurs de fil d'antenne (404) et/ou les paires de capteurs de fil d'antenne sont disposés et conçus pour tendre respectivement en coopération une section des fils d'antenne (200a, 200b), de sorte que la section des fils d'antenne (200a, 200b) présente respectivement une tension de matériau.

3. Le dispositif selon l'une quelconque des revendications précédentes, dans lequel
Le dispositif de transport de fils (202a, 202b, 204, 206) comprend une ou plusieurs poulies de mise à disposition (202a, 202b) et/ou une ou plusieurs poulies de renvoi (204) et/ou une poulie de réception (206).

4. Le dispositif selon l'une quelconque des revendications précédentes, comprenant en outre
- un dispositif de pose agencé et configuré pour mettre en contact les au moins deux fils d'antenne (200a, 200b) respectivement avec un capteur de fil d'antenne (404) d'une unité de transport de fil (402a, 402b) et/ou avec une paire de récepteurs de fil d'antenne d'une unité de transport de fil (402a, 402b), de sorte que les fils d'antenne (200a, 200b) présentent une tension de matériau entre deux capteurs de fil d'antenne (404) ou paires de récepteurs de fil d'antenne respectivement espacés.

5. Le dispositif (1000) pour la fabrication de transpondeurs RFID, présentant
- une surface de glissement, et
- un dispositif de transport de fil (202a, 202b, 204, 206) agencé et configuré pour transporter au moins deux fils d'antenne (200a, 200b) à travers la surface de glissement dans une direction de transport (F), dans lequel
le dispositif de transport de fils est en outre agencé et conçu pour, en coopération avec la surface de glissement, tendre les au moins deux fils d'antenne (200a, 200b) parallèlement l'un à l'autre au moins par sections, de sorte que les fils d'antenne (200a, 200b) parallèles l'un à l'autre par sections présentent une tension de matériau le long de la direction de transport (F) ; et
- au moins un dispositif de placement (304) qui est disposé et conçu pour disposer une puce de transpondeur (10 ; 20) entre les fils d'antenne (200a, 200b) tendus dans la direction de transport (F).

6. Le dispositif selon la revendication précédente, comprenant en outre
- au moins un dispositif de transport de support (104, 106, 108) agencé et configuré pour transporter un support de traitement (100), en particulier un papier siliconé, dans la direction de transport (F) entre la surface de glissement (102) et les fils d'antenne (200a, 200b), et/ou dans lequel
le dispositif de transport de documents (104, 106, 108) présente un rouleau de mise à disposition de documents (104) et/ou un ou plusieurs rouleaux de renvoi (106) et/ou un rouleau de réception de documents, et/ou
le dispositif de transport de documents (104, 106, 108) est en outre agencé et conçu pour tendre le support de traitement (100) en coopération avec la surface de glissement (102), de sorte que le support de traitement (100) présente une tension de matériau dans la direction de transport (F), et/ou dans lequel
le dispositif de transport de support (104, 106, 108) transporte le support de traitement (100) et le dispositif de transport de fil (202a, 202b, 204, 206) avec les unités de transport de fil (402a, 402b) transporte les fils d'antenne (200a, 200b) respectivement à la même vitesse de transport, et/ou dans lequel
le dispositif de transport de support (104, 106, 108) transporte le support de traitement (100) et le dispositif de transport de fil (202a, 202b, 204, 206) avec les unités de transport de fil (402a, 402b) transporte les fils d'antenne (200a, 200b) respectivement en cadence, et/ou dans lequel
le dispositif de transport de support (104, 106, 108) avec les unités de transport de fil (402a, 402b) est en outre disposé et conçu pour disposer le support de traitement (100) en contact au moins par sections avec la surface de glissement (102) et pour transporter le support de traitement (100) avec un frottement de glissement sur la surface de glissement (102), et/ou dans lequel
le dispositif de transport de fils (202a, 202b, 204, 206) avec les unités de transport de fils (402a, 402b) est disposé et conçu pour disposer les fils d'antenne (200a, 200b) au moins par sections en contact avec la surface de glissement (102) et pour transporter les fils d'antenne (200a, 200b) avec un frottement de glissement sur la surface de glissement (102), ou dans lequel
le dispositif de transport de fils (202a, 202b, 204, 206) avec les unités de transport de fils (402a, 402b) est disposé et conçu pour disposer les fils d'antenne (200a, 200b) au moins par sections en contact avec le support de traitement (100).

7. Le dispositif selon l'une quelconque des revendications précédentes, dans lequel
le dispositif de placement (304) est agencé et conçu pour modifier localement et temporairement une distance (D1) des fils d'antenne (200a, 200b) transportés parallèlement les uns aux autres au moins par tronçons, de sorte que les fils d'antenne (200a, 200b) présentent temporairement entre eux, dans la zone du dispositif de placement (304), une distance d'équipement (D2) qui est supérieure à la distance (D1) des fils d'antenne (200a, 200b) parallèles les uns aux autres au moins par tronçons, en dehors de la zone du dispositif de placement (304), et/ou dans lequel
le dispositif de placement (304) présente un ou plusieurs éléments de modification de l'espacement, en particulier des broches d'espacement (304b), qui sont
i) peuvent être abaissés et relevés parallèlement à une normale à la surface d'un plan passant par les fils d'antenne (200a, 200b) parallèles entre eux au moins par sections, les éléments de modification de l'écartement étant disposés entre les fils d'antenne (200a, 200b) transportés dans un état abaissé et n'étant pas disposés entre les fils d'antenne (200a, 200b) dans un état relevé, et/ou qui
ii) sont respectivement mobiles dans une direction (R) et dans une direction opposée (R') à la direction, la direction (R) et la direction opposée (R') étant respectivement parallèles à la direction de transport (F) et orthogonales à la normale à la surface du plan passant par les fils d'antenne (200a, 200b) parallèles entre eux au moins par tronçons.

8. Le dispositif selon l'une quelconque des revendications précédentes, comportant en outre
- un distributeur de flux (302) agencé et configuré pour appliquer un flux (30a, 30b) sur chacun des fils d'antenne (200a, 200b) ; et/ou
- un dispositif de soudage qui est disposé et conçu pour appliquer une soudure sur les fils d'antenne (200a, 200b) et/ou sur une puce de transpondeur (10 ; 20) et pour souder les fils d'antenne (200a, 200b) à une puce de transpondeur (10 ; 20) disposée entre eux ; et/ou
- un dispositif de connexion (306) agencé et conçu pour établir une connexion électriquement conductrice (201) entre les fils d'antenne (200a, 200b) ; et/ou
- un dispositif d'isolation (308) qui est agencé et conçu pour entourer au moins une partie des fils d'antenne (200a, 200b) et/ou au moins une partie de la connexion électriquement conductrice (201) avec un matériau isolant (32) ; et/ou
- un dispositif de sectionnement (310), en particulier un dispositif de sectionnement au laser, qui est agencé et conçu pour sectionner au moins une partie des fils d'antenne (200a, 200b) et/ou au moins une partie du matériau isolant (32) ; et/ou
- un dispositif de scellement (312) agencé et conçu pour appliquer un scellement (36) sur au moins une partie de la puce de transpondeur (10 ; 20) et/ou au moins une partie du matériau isolant (32) et ou au moins une partie des fils d'antenne (200a, 200b) ; et/ou
- un dispositif d'inspection (314) qui est disposé et conçu pour déterminer les défauts de propriété et/ou de positionnement d'une puce de transpondeur (10 ; 20) et/ou d'un ensemble de transpondeurs ; et/ou
- un dispositif d'individualisation qui est disposé et conçu pour sectionner respectivement les fils d'antenne (200a, 200b) et/ou le matériau isolant (32), de sorte qu'il se forme respectivement un agencement de transpondeurs individualisé avec au moins une puce de transpondeur (10 ; 20) et au moins un agencement d'antennes, en particulier une antenne à boucle, où
l'agencement d'antenne, en particulier l'antenne à boucle, de l'agencement de transpondeur comprend une section des fils d'antenne (200a, 200b) coupés et/ou de la connexion électriquement conductrice (201).

9. Un procédé de fabrication de transpondeurs RFID, comprenant les étapes suivantes :
- Préparation d'au moins deux fils d'antenne (200a, 200b) qui sont transportés dans une direction de transport (F) par un dispositif de transport de fils (202a, 202b, 204, 206) comprenant au moins deux unités de transport de fils (402a, 402b), dans lequel
les unités de transport de fil (402a, 402b) sont disposées et conçues pour, en coopération, tendre les fils d'antenne (200a, 200b) l'un par rapport à l'autre au moins par sections parallèles et selon un angle de sensiblement 90° par rapport à la direction de transport (F), de sorte que les fils d'antenne (200a, 200b) parallèles l'un à l'autre par sections présentent une tension de matériau selon un angle de sensiblement 90° par rapport à la direction de transport (F) ; et
- Disposer (S2) une puce de transpondeur (10 ; 20) entre les fils d'antenne (200a, 200b) parallèles entre eux au moins par sections et tendus selon un angle de sensiblement 90° par rapport à la direction de transport (F).

10. Le procédé selon la revendication précédente, comprenant en outre au moins une des étapes :
- application (S1) d'une couche de flux (30) sur les fils d'antenne (200a, 200b) ; et/ou
- application d'une brasure sur les fils d'antenne (200a, 200b) et/ou sur une puce de transpondeur (10 ; 20) et soudage des fils d'antenne (200a, 200b) parallèles entre eux au moins par sections à une puce de transpondeur (10 ; 20) disposée entre les fils d'antenne (200a, 200b) ; et/ou
- établir (S4) au moins une connexion électriquement conductrice (201) entre les au moins deux fils d'antenne (200a, 200b) ; et/ou
- entourer (S5) au moins une partie des fils d'antenne (200a, 200b) et/ou au moins une partie de la connexion électriquement conductrice (201) avec un matériau isolant (32) ; et/ou
- couper (S6) au moins une partie des fils d'antenne (200a, 200b) et/ou au moins une partie du matériau isolant (32) ; et/ou
- application (S8) d'un scellement (36) sur au moins une partie de la puce de transpondeur (10 ; 20) et/ou sur le matériau isolant (32) et/ou sur les fils d'antenne (200a, 200b) ; et/ou
- la détection (S9) d'erreurs de propriétés et/ou de positionnement d'une puce de transpondeur (10 ; 20) et/ou d'un ensemble de transpondeurs.
